# EUROPEAN PATENT SPECIFICATION

(11) **EP 1 573 902 B1**
(45) Date of publication and mention of the grant of the patent: **16.01.2013**
(21) Application number: 02780188.5
(22) Date of filing: 22.11.2002
(51) Int. Cl.: H03F 1/32

(54) **REAL-TIME DIGITAL PHASE AND GAIN ADAPTATION METHOD USING FEEDBACK AND ARRANGEMENT USING SUCH A METHOD**
METHODE ZUR DIGITALE PHASEN- UND VERSTÄRKUNGSANPASSUNG IN ECHTZEIT MIT HILFE VON SIGNALRÜCKKOPPLUNG SOWIE DIESE METHODE VERWENDENDES GERÄT
PROCEDE D'ADAPTATION DE GAIN ET DE PHASE NUMERIQUE EN TEMPS REEL PAR RETROACTION ET SYSTEME METTANT EN OEUVRE UN TEL PROCEDE

(43) Date of publication of application: 14.09.2005
(73) Proprietor: Telefonaktiebolaget L M Ericsson (Publ), 164 83 Stockholm (SE)
(72) Inventor: KOKKELER, André, NL-7623 HB Borne (NL)
(74) Representative: Hatzmann, Martin
(86) International application number: PCT/NL2002/000757
(87) International publication number: WO 2004/049558

(56) References cited:
- WO-A-01/08297
- US-A- 5 900 778
- US-A- 6 072 364
- US-B1- 6 313 703

## Description

### Field of the invention

The present invention relates to an arrangement of real-time digital phase and gain adaptation according to the preamble of claim 1. Also, the present invention relates to a method according to the preamble of claim 9.

### Prior art

Such a system and method are known in areas in which a combination of analogue and digital components, subsystems or systems are used with a digital input signal and an analogue output signal and where the bandwidth is relatively large. An important example of an application using such a system and method is the third generation wireless telephony system UMTS (Universal Mobile Telecommunications System).

Within many electronic systems for telecommunication, the performance of such a system is limited by the non-linear behaviour of Digital to Analogue Converters (DAC) and Analogue to Digital Converters (ADC), analogue components, analogue systems and subsystems. There are several effects of this non-linear behaviour:
- the relation between an input amplitude (or envelope) and an output amplitude (or envelope) is not linear,
- the phase relation between the absolute phase of the input signal and the absolute phase of the output signal of a system varies as a function of frequency (frequency-dependent phase),
- the overall gain (i.e., the power of the output signal relative to the power of the input signal) varies as a function of frequency (frequency-dependent gain).

In the remainder of this document the non-linear relation between an input amplitude (or envelope) and an output amplitude (or envelope) will be referred to as "gain as a function of amplitude". Real-time adaptation of the gain as a function of amplitude when applied to amplifiers is widely known as "digital predistortion". It is used to compensate the non-linear transfer function of (power) amplifiers.

Determining the phase and gain as a function of frequency is currently mainly based on careful selection and design of the analogue parts of a system. Furthermore, equalisation techniques are used to compensate for the non-uniform gain-frequency relation of transmission media.

In many applications of electronic systems for (tele-)communication, active control over especially the phase behaviour as a function of frequency is very important. For example, in beam forming with an antenna array comprising an assembly of several antennas, the direction in which the antenna array transmits and receives energy is steered by the control over the relative phase of the signal at each individual antenna. A frequency-dependent phase shift is necessary to properly steer beams at all relevant frequencies.

Frequency-dependent phase shift for phase adaptation may be used on various component levels in relation to e.g., calibration of antenna arrays in broadband systems, and linearisation (of phase and amplitude as a function of frequency) of analogue components.

Methods exist for calibration of the total power (power integrated over frequency) and average phase (phase averaged over frequency) in real-time. In all these methods, a dedicated feedback loop is used to measure the total power and the average phase of the output signal. For narrow-band systems, this solution may be sufficient, but for broad-band systems, such as UMTS, especially frequency-dependent phase deviations may still be significant.

An important application of Real-time Frequency-Dependent phase and gain calibration is within the area of antenna array transmitters, used in beam forming applications. Side-lobe distortion of the beam is the driving concern for most antenna array systems. This distortion is mainly caused by deviations from the ideal case of the phase of the signals transmitted at the individual array elements (antennas).

For narrow-band systems, phase-related deviations of signals are assumed to be constant over the entire frequency band.

For broad-band systems, such as Wide-band Code Division Multiple Access (WCDMA) systems, the phase deviations vary for different frequencies. The frequency dependent deviations typically measured within WCDMA systems, not using phase calibration, can be determined and are found to be typically ±9°, due to Saw Filter ripple and low Voltage Standing Wave Ratio (VSWR) terminations of the feeder cable. As known to persons skilled in the art, it can be shown that this deviation would lead to array average side-lobes, which are about 10 dB below the isotropic radiation pattern of the antenna array.

It has been indicated in Candidate Calibration Architectures for Use in URTRA Adaptive Antenna Base-stations, K.A. Morris, C.M. Simmonds and M.A. Beach, in: Advanced Communications Technologies and Services (ACTS) 1999, that the typical phase matching needed within adaptive antenna systems equals 3°, which yields an array average side-lobe level of -20 dB. Thus, for sufficient reduction of side-lobe distortion, the frequency-dependent phase deviation has to be reduced from ±9° to ±3°.

In prior art system it is not possible to change the gain and phase as a function of frequency in real-time without, disadvantageously, interrupting the normal data-flow of input and output signals maintained by the electronic system.

In other prior art systems where only the total power and/or the average phase are calibrated (without interruption of normal data flow), disadvantageously the pointing accuracy of a beam forming system, such as an antenna array, is limited and, therefore, more energy is used than needed in case of correct calibration, to guarantee a certain quality for the users. Furthermore, the side-lobe levels in the beam broadcasted by the antenna array are higher, increasing the overall interference levels (between various antenna arrays within a network and also single antenna systems (e.g. mobile phones) within a network), reducing overall system capacity. Other art is taught in WO 01/08297, U56313703, and US5900778.

### Summary of the invention

In the present invention it is recognised that real-time adaptation of the frequency-dependent phase and gain is required to improve the beam forming.

It is an object of the present invention to provide an arrangement as defined in the preamble of claim 1 that is capable of correcting gain as a function of amplitude and of correcting frequency-dependent gain and phase for any type of device with a digital input signal and analogue output signal.

The present invention provides an arrangement as defined in claim 1.

The arrangement according to the present invention achieves that the predistortion of the input signal is such that the output signal transmitted at the antenna is to be substantially undistorted relative to the input signal.

Advantageously, this arrangement allows the real-time adaptation of phase and gain as a function of frequency without interrupting the normal data-flow of input and output signals.

Furthermore, the present invention relates to a computer program product, to a data carrier with a computer program product, as well as additional arrangements and methods.

### Brief description of drawings

Below, the invention will be explained with reference to some drawings, which are intended for illustration purposes only and not to limit the scope of protection which is defined in the accompanying claims.
Figure 1 shows a block diagram for digital predistortion of a power amplifier in a transmitter according to the prior art;
Figure 2 shows a block diagram for frequency-dependent phase calibration of an antenna transmitter according to the prior art;
Figure 3 shows a block diagram for digital predistortion of a power amplifier and phase calibration in a transmitter according to the present invention;
Figure 4 shows a detailed block diagram for real-time phase adaptation and phase estimation of a power amplifier in a transmitter according to the present invention;
Figure 5 shows a block diagram of a generalised adaptation and estimation scheme for a system in accordance with the present invention.

### Description of preferred embodiments

In the following description, the present invention will be described with reference to a transmitter (e.g., an antenna array). It is noted that the principles disclosed here to design a transmitter with digital predistortion and phase calibration can be generalised to a method for correction of gain as a function of amplitude, delay and frequency-dependent gain and phase for any type of device with a digital input signal and an analogue output signal.

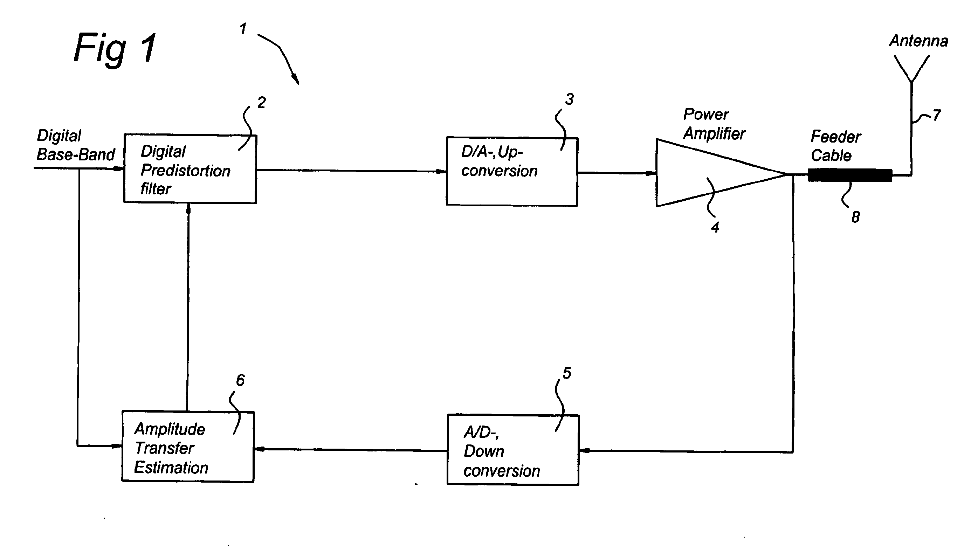

Figure 1 shows a block diagram for digital predistortion of a power amplifier in a transmitter according to the prior art.

A transmitting antenna array generally exists of multiple, functionally identical transmitters. A block diagram of a typical transmitter according to the prior art and including a digital predistortion device for the power amplifier, is given in Figure 1.

A transmitter 1 comprises a digital predistortion block 2, digital-analogue converter and up-converter 3, a power amplifier 4, analogue-digital converter and down-converter 5, an amplitude transfer estimation block 6, an antenna 7 and feeder-cable 8.

The digital predistortion block 2 comprises a first input for entry of digital base-band signals. An output of digital predistortion block 2 is connected to an input of digital-analogue converter and up-converter 3. An output of digital-analogue converter and up-converter 3 is connected to an input of power amplifier 4. An output of power amplifier 4 is connected to an input of analogue-digital converter and down-converter 5. An output of analogue-digital converter and down-converter 5 is connected to a first input of amplitude transfer estimation block 6. An output of amplitude transfer estimation block 6 is connected to a second input of digital predistortion block 2.

The power amplifier 4 is further connected at it's output to antenna 7 by means of feeder-cable 8.

The digital base-band signal to be transmitted by the transmitter is input at the first input of the digital predistortion block 2, and also at a second input of the amplitude transfer estimation block 6. The digital predistortion block 2 and power amplifier process the signals digitally. The digital-analogue converter and up-converter 3 converts the digital signals into analogue signals that can be transmitted by the antenna 7.

The predistortion mechanism corrects the gain as a function of amplitude, which results in a linearisation of the power amplifier 4. However, this prior art system does not have a facility to correct frequency-dependent phase deviations.

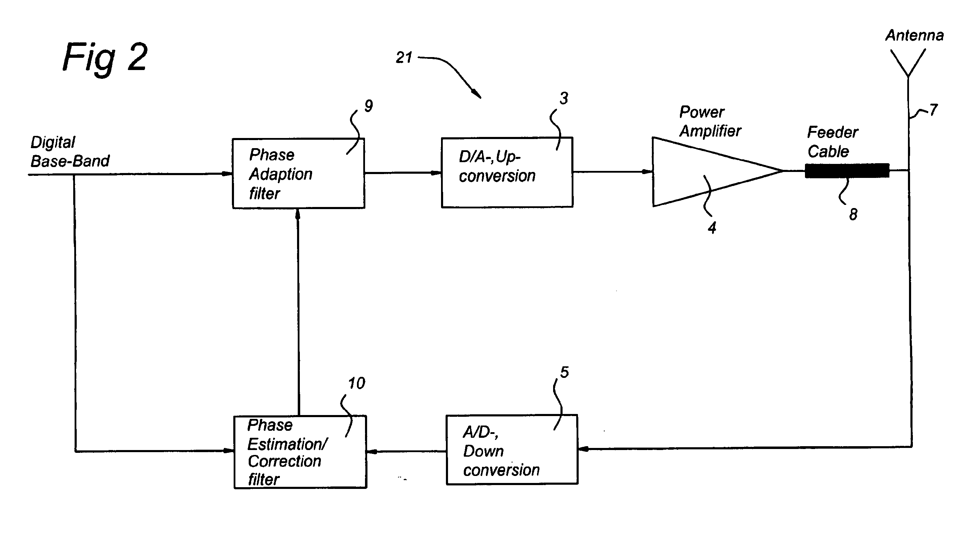

Figure 2 shows a block diagram for calibration of an antenna transmitter according to the prior art.

Again, a block diagram of a typical transmitter is used to explain the calibration of an antenna transmitter. Figure 2 shows a second transmitter 21 including a calibration device for the frequency-dependent phase calibration. In Figure 2, items with the same reference numbers refer to the same items as shown in Figure 1.

The second transmitter 21 comprises a phase adaptation block 9, digital-analogue converter and up-converter 3, power amplifier 4, analogue-digital converter and down-converter 5, a phase estimation and correction block 10, antenna 7 and feeder-cable 8.

The phase adaptation block 9 comprises a first input for entry of digital base-band signals. An output of phase adaptation block 9 is connected to an input of digital-analogue converter and up-converter 3. An output of digital-analogue converter and up-converter 3 is connected to an input of power amplifier 4. An output of power amplifier 4 is connected to the feeder cable 8 which provides a further connection to the antenna 7. On the side of the antenna 7, a connection is provided to an input of analogue-digital converter and down-converter 5. An output of analogue-digital converter and down-converter 5 is connected to a first input of phase estimation and correction block 10. An output of phase estimation and correction block 10 is connected to a second input of phase adaptation block 9.

The digital base-band signal to be transmitted by the transmitter is input at the first input of the phase adaptation block 9, and also at a second input of the phase estimation and correction block 10. Similar to the predistortion block 2, the phase adaptation block 9 and phase estimation and correction block 10 process signals in the digital domain, while the signal transmitted by the antenna 7 is analogue.

Within the system shown in Figure 2, the signals are sampled by block 5 at the antenna 7, after passage through the feeder cable 8. The calibration scheme does not linearise the power amplifier 4.

Correction applied to the input signal is frequency-dependent.

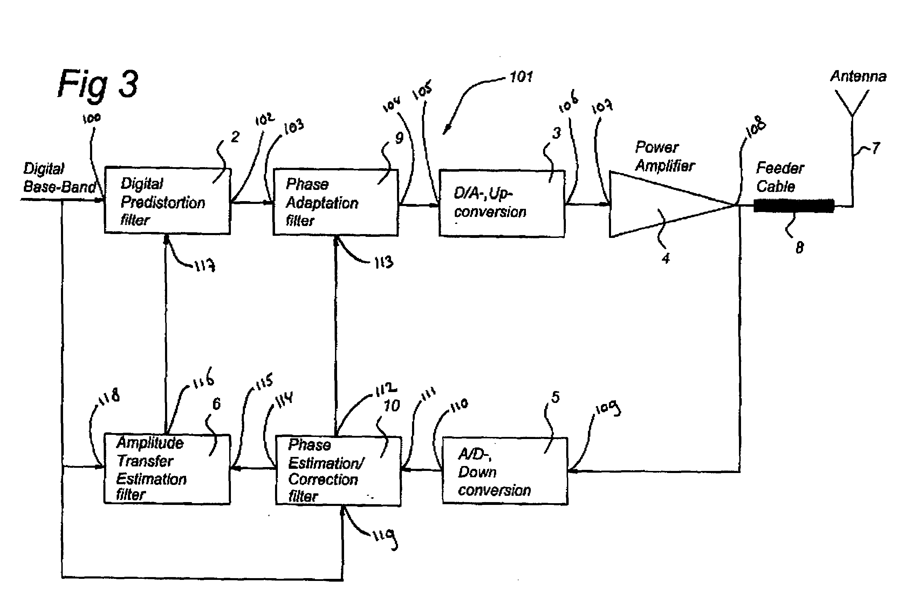

To obtain real-time digital phase and gain adaptation of signals by using feedback, a straightforward combination of the schemes as shown in Figure 1 and 2 would result in the use of two separate feedback paths: one used for digital predistortion, another used for calibration. However, in the present invention it is recognised that the digital predistortion scheme shown in Figure 1 can be combined with the calibration scheme of Figure 2 as a new scheme which uses only a single feedback loop and a concatenation of the estimation and correction mechanisms. The resulting system is a transmitter 101 as presented in Figure 3.

Figure 3 shows a block diagram for digital predistortion of the power amplifier and phase calibration in the transmitter 101 according to the present invention. In Figure 3, items with the same reference numbers refer to the same items as shown in Figures 1 and 2.

The digital predistortion block 2 comprises a first input 100 for entry of digital base-band signals. An output 102 of digital predistortion block 2 is connected to an input 103 of the phase adaptation block 9. An output 104 of phase adaptation block 9 is connected to an input 105 of digital-analogue converter and up-converter 3. An output 106 of digital-analogue converter and up-converter 3 is connected to an input 107 of power amplifier 4. An output 108 of power amplifier 4 is connected to an input 109 of analogue-digital converter and down-converter 5. An output 110 of analogue-digital converter and down-converter 5 is connected to a first input 111 of the phase estimation and correction block 10. A first output 112 of the phase estimation and correction block 10 is connected to a second input 113 of the phase adaptation block 9. A second output 114 of the phase estimation and correction block 10 is connected to a first input 115 of the amplitude transfer estimation block 6. A first output 116 of the amplitude transfer estimation block 6 is connected to the second input 117 of the predistortion block 2.

The power amplifier 4 is further connected at it's output 108 to antenna 7 by means of feeder-cable 8.

The digital base-band signal to be transmitted by the transmitter is input at the first input 101 of the digital predistortion block 2, at a second input 118 of the amplitude transfer estimation block 6 and at a second input 119 of the phase estimation and correction block 10.

The signal to be transmitted by the antenna 7 is sampled by analogue-digital converter and down-converter 5. The sampled signal is fed to the first input 111 of the phase estimation and correction block 10. By comparison with the (original) digital base-band signal, available at the second input 119 of the phase estimation and correction; block 10, the sampled signal is used to determine a first control signal that is fed to the second input 113 of the phase adaptation block 9 to adapt the settings of the phase adaptation block 9. Simultaneously, an adapted sampled signal is derived from the sampled signal by the phase estimation and correction block 10 and fed to the first input 115 of the amplitude transfer estimation block 6. By comparison with the digital base-band signal, available at the second input 118 of the amplitude transfer estimation block 6, the adapted sampled signal is used to determine a second control signal that is fed to the second input 117 of the digital predistortion block 2 to adapt the settings of the digital predistortion block 2.

The biggest advantage of this scheme is that only a single feedback path is used for both digital predistortion 2 and phase adaptation (or calibration) 9. It is noted that as an alternative for the scheme shown in Figure 3, the combination of blocks 9 and 10 and the combination of blocks 2 and 6, may be interchanged. In Figure 3 the second control signal is derived from the sampled signal after determining the first control signal. In the alternative scheme the determination of the first and second control signal is reversed: the first control signal for phase adaptation is derived after determining the second control signal for predistortion.

A consequence of the scheme shown in Figure 3 (and it's alternative) is that the feeder cable 8 is not calibrated. The frequency-dependent phase effects of feeder cables are normally small. Delay differences of signals traversing the feeder cable 8 may exist. These delay differences can be measured during installation and be corrected in a prior stage. Alternatively, the feeder cable 8 can be included in the circuit of the present invention by connecting the point between the feeder cable 8 and the antenna 7 to the first input of the phase estimation and correction block 10, similar to the connection scheme as shown in Figure 2.

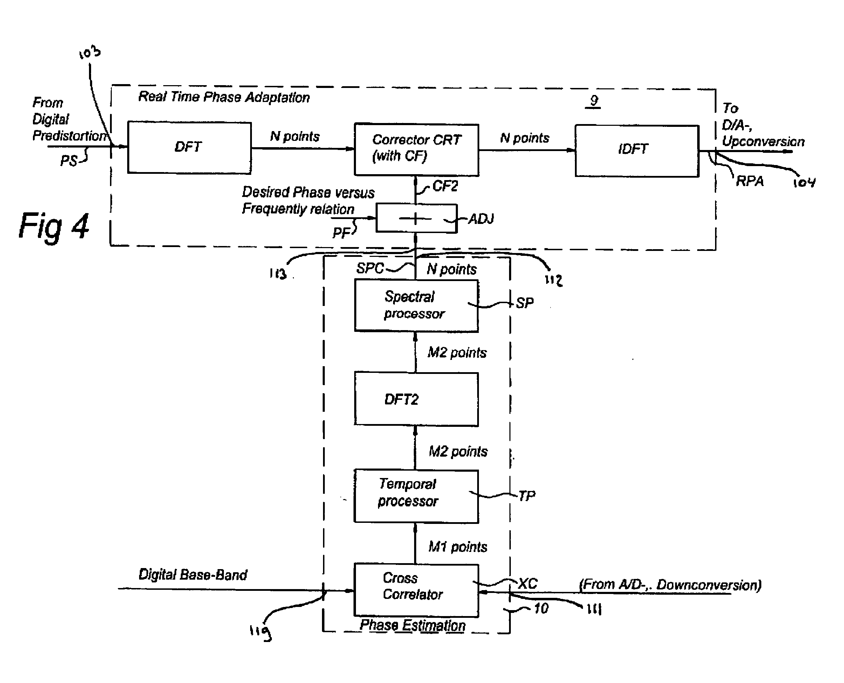

An embodiment of the frequency-dependent phase calibration as represented by the phase adaptation block 9 and the phase estimation and correction block 10 is presented in Figure 4.

Figure 4 shows a detailed block diagram for real-time phase adaptation and phase estimation in accordance with the present invention.

The block diagram shown in Figure 4 is a detailed part of the blocks 9 and 10 of Figure 3.

The phase adaptation block 9 comprises a first digital Fourier transform processor DFT, a corrector CRT, an inverse digital Fourier transform processor IDFT, and an adjuster ADJ. The digital Fourier transform processor DFT is connected to a first input of corrector CRT. Corrector CRT is connected at an output to an input of the inverse digital Fourier transform processor IDFT. Further, adjuster ADJ is connected with an output to a second input of corrector CRT. The digital Fourier transform processor DFT receives at it's input the predistorted signal PS from the output of the predistortion block 2. The adjuster ADJ receives at a first input 113 a spectral signal SPC from the phase estimation and correction block 10, and at a second input a phase-frequency signal PF representing a desired phase and frequency relation. A real-time phase adapted signal RPA is outputted by the inverse digital Fourier transform processor IDFT and passed on to the input of the digital-analogue converter and up-converter 3. The base-band signal and the signals PS, SPC, PF, and RPA are all in the digital domain.

The phase estimation and correction block 10 comprises a cross-correlator XC, a temporal processor TP, a second digital Fourier transform processor DFT2, and a spectral processor SP. The cross-correlator XC receives on a first input 119 a signal to be transmitted from the digital base-band and on a second input 111 the transmitted signal from the analogue-digital converter and down converter 5. The cross-correlator XC is connected at an output to an input of the temporal processor TP. The temporal processor TP is connected at an output to an input of the second digital Fourier transform processor DFT2. The second digital Fourier transform processor DFT2 is connected at an output to an input of the spectral processor SP. Finally, the spectral processor SP is connected at an output to the first input of the adjuster ADJ.

The predistorted data signal PS from the digital predistortion block 2 is divided into blocks of length N. A digital Fourier transform is executed in the first digital Fourier transform processor DFT using this data to calculate a representation in the frequency domain. Note that if N=2^{k}, with k bering a positive integer number, a Fast Fourier Transform algorithm can be used. A phase correction in the corrector CRT, which performs a complex multiplication per frequency point using correction factors CF obtained from the adjuster ADJ, then determines the relative phase for every frequency point (of N points). Then, the inverse digital Fourier transform processor IDFT performs an inverse digital Fourier transform or an inverse fast Fourier transform algorithm (in case N=2^{k}), which transfers the signal from the frequency domain back into the time domain as a real-time phase adapted signal RPA.

The phase estimation and correction block 10 divides both the signal it receives from the feedback path on its second input and the original digital base-band signal (received on its first input) into blocks of data. The cross-correlator XC synchronises and then cross-correlates the two blocks of data into M1 cross correlation points. Different cross-correlation functions can be used, generally subdivided into 2 classes:
1. every point of the correlation function is based on the same amount of data from the first and the second input. Generally, as known to persons skilled in the art, this is not the most efficient implementation of the correlation function,
2. usually, points of the correlation function are based on different amounts of data from the first and second input.

Next, the temporal processor TP performs an algorithm to change the number of points of the correlation function from M1 points to M2 points. For example: an averaging procedure to reduce the number of points and interpolation to increase the number of points. Also, M1 may equal M2.

Next, the second digital Fourier transform processor DFT2 (in case M2=2^{j}, with j being a positive integer, a fast Fourier transform (FFT) can be used) is used to translate the cross correlation function into a power spectrum by an digital Fourier transform or an FFT (in case M2=2^{j}).

Then, the spectral processor SP performs a spectral processing to obtain an estimate of the phase as a function of frequency being represented as an N-point spectral signal SPC. The N-point spectral signal SPC is outputted by the spectral processor SP to the first input of the adjuster ADJ. The adjuster ADJ calculates new correction factors CF2 to obtain the desired phase-frequency-relation (as received on the second input of ADJ). The new correction factors CF2 are then inputted in the corrector CRT to replace former correction factors CF.

According to the present invention, phase errors of an antenna array can be reduced to ±0.2° without disturbing the digital predistortion of the power amplifier 4.

In this embodiment, the phase adaptation block 9 and the phase estimation and correction block 10 are embodied by various computational devices DFT, CRT, IDFT, ADJ, XC, TP, DFT2, and SP. It is noted that, alternatively, several or all of these computational devices may be combined in one or more special-purpose processors. In a further embodiment, phase adaptation block 9 and the phase estimation and correction block 10 may be present as software-modules loaded and executed in one or more processors.

The advantage of using this new scheme which uses only a single feedback loop and a concatenation of the estimation and correction mechanisms as shown in Figure 3 and 4, real-time phase and gain adaptation according to the present invention is that no tuning procedures for the hardware, including the power amplifier, are needed during production, installation and lifetime of the product. Further, the phase calibration according to the present invention uses less components than in systems of the prior art. This has positive effects on costs, size of the product, power consumption and reliability.

Implementing frequency-dependent phase adaptation in the digital domain has several advantages. Standard processors and their software libraries accommodate fast implementation, which makes it easy to evaluate several alternative adaptation algorithms for the computational devices DFT, CRT, IDFT, ADJ, XC, TP, DFT2, and SP. Another advantage of implementation in the digital domain is that the system is much less dependent on environmental conditions compared to systems where adaptation is done in the analogue domain.

Because of real-time adaptation, the pointing accuracy of beam forming antenna arrays is increased and the average side-lobe levels are reduced. As a consequence, less energy is used to achieve a guaranteed quality of connections within a wireless system which can be translated into a higher capacity (i.e., in terms of throughput or traffic density).

From the transmission system 101 according to the present invention as described above, a more general system with digital adaptation can be derived and a method to compose such a system.

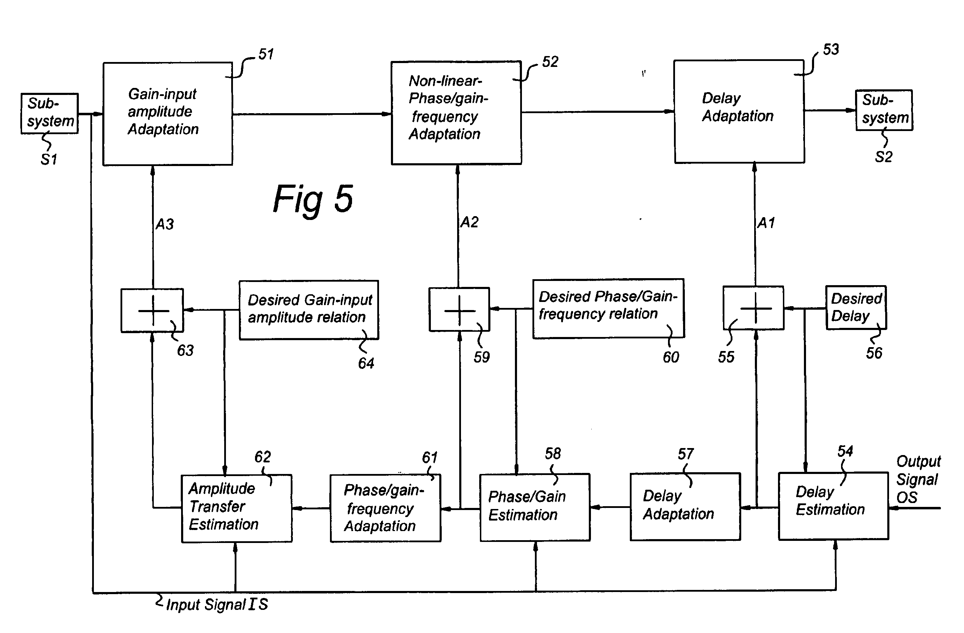

Figure 5 shows a block diagram of a generalised adaptation and estimation system in accordance with the present invention.

Here it is assumed that the generalised adaptation and estimation system in accordance with the present invention is positioned in between two subsystems, viz. a first subsystem S1 and a second subsystem S2. First subsystem S1 generates an incoming signal to be handled further by second subsystem S2. The generalised adaptation and estimation system according to the present invention is designed to perform a general correction of gain as a function of amplitude, delay, phase as a function of frequency and gain as a function of frequency on the signal originated in first subsystem S1 before passing the signal on to subsystem S2.

Such a generalised adaptation and estimation system comprises a gain-input amplitude adaptation device 51, a non-linear phase and gain-frequency adaptation device 52, a first delay adaptation device 53, a delay estimation device 54, a delay adjuster 55, a second delay adaptation device 57, a phase and gain estimation device 58, a phase and gain adjuster 59, a phase and gain frequency adaptation device 61, an amplitude transfer estimation device 62, and a gain adjuster 63.

Gain-input amplitude adaptation device 51 is connected at an output to a first input of non-linear phase and gain-frequency adaptation device 52. Further, an input of gain-input amplitude adaptation device 51 is connected to an output of first subsystem S1 to receive signals from subsystem S1 over incoming signal path IS.

Non-linear phase and gain-frequency adaptation device 52 is connected at an output to a first input of first delay adaptation device 53.

First delay adaptation device 53 is connected at an output to second subsystem S2.

Delay estimation device 54 is connected at a first input to a feedback signal from the second subsystem S2 over output signal feedback path OS. Also, delay estimation device 54 is connected at a second input to the signal originated in the first subsystem S1 over incoming signal path IS. Further, delay estimation device 54 is connected at a third input to a signal which represents the desired delay 56. Finally, delay estimation device 54 is connected at an output to an input of delay adjuster 55 and an input of second delay adaptation device 57.

Delay adjuster 55 is further connected at a second input to the signal representing the desired delay 56. At its output, delay adjuster 55 is connected to a second input of delay adaptation device 53 for sending a delay-related adaptation input signal A1.

Second delay adaptation device 57 is at its output connected to a first input of phase and gain estimation device 58.

Phase and gain estimation device 58 is connected at a second input to the signal originated in the first subsystem S1 over incoming signal path IS. Further, phase and gain estimation device 58 is connected at a third input to a signal which represents the desired phase and gain as a function of frequency 60. Finally, phase and gain estimation device 58 is connected at an output to an input of phase and gain adjuster 59 and an input of phase and gain frequency adaptation device 61.

Phase and gain adjuster 59 is further connected at a second input to the signal representing the phase/gain frequency relation. At its output, phase and gain adjuster 59 is connected to a second input of non-linear phase and gain-frequency adaptation device 52 for sending a phase- and gain-related adaptation input signal A2.

Phase and gain frequency adaptation device 61 is at its output connected to a first input of amplitude transfer estimation device 62.

Amplitude transfer estimation device 62 is connected at a second input to the signal originated in the first subsystem S1 over incoming signal path IS. Further, amplitude transfer estimation device 62 is connected at a third input to a signal which represents the desired gain-input amplitude relation 64. Finally, amplitude transfer estimation device 62 is connected at an output to an input of gain adjuster 63.

Gain adjuster 63 is further connected at a second input to the signal which represents the desired gain amplitude relation 64. At its output, gain adjuster 63 is connected to a second input of gain amplitude adaptation device 51 for sending a gain-input amplitude -related adaptation input signal A3.

The purpose of the scheme shown in Figure 5 is to modify any subset of the 4 possible relations (gain as a non-linear function of frequency , phase as a non-linear function of frequency, delay( i.e., linear "gain as a function of frequency and phase as a function of frequency"-adaptation) and gain as a function of amplitude) of second subsystem S2. Second subsystem S2 has a digital input and an analogue output, is preceded by first subsystem S1 (although not necessarily) and (possibly) followed by at least one further subsystem S3.

In order to enable the adaptation of a subset of relations, 3 functional blocks are added: a real-time adaptation block (51, 52, 53), a feedback path (OS) and a parameter estimation block (54, 55, 56, 57, 58, 59, 60, 61, 62, 63 and 64). To adapt the relations, the incoming signal is modified digitally by the real-time adaptation block (51, 52, 53). The modified data is then transferred through second subsystem S2, possibly sent to a further subsystem S3 and transferred through a feedback path OS to the parameter estimation block (54, 55, 56, 57, 58, 59, 60, 61, 62, 63 and 64). The parameter estimation block (54, 55, 56, 57, 58, 59, 60, 61, 62, 63 and 64) compares the original incoming signal over incoming signal path IS with the output signal received over output signal feedback path OS, determines the characteristics of the relations mentioned and determines the parameters for the real-time adaptation in the real-time adaptation block (51, 52, 53).

Two different sets of relations can be identified: a first set is based on gain as a function of amplitude and a second set is based on phase as a function of frequency and gain as a function of frequency. It is noted that delay of signals causes a linear phase deviation as a function of frequency. The real-time adaptation block (51, 52, 53) and the parameter estimation blocks (54, 55, 56, 57, 58, 59, 60, 61, 62, 63 and 64) deal with these sets of relations in a separate manner.

The real-time adaptation block is split into a "gain as function of amplitude"-adaptation and "phase as a function of frequency and gain as a function of frequency" adaptation, where the adaptation by "phase as a function of frequency and gain as a function of frequency" is split into a non-linear part and a linear part. The non-linear part relates to non-linear "phase as a function of frequency and gain as a function of frequency" adaptation. The linear part relates to a linear "phase as a function of frequency and gain as a function of frequency" adaptation, i.e., a delay adaptation.

The estimation process is split as well but the order in which the parameters are estimated is reversed: first the delay is determined, then the phase and gain as a function of frequency is determined, and finally, the gain as a function of amplitude is determined. In order to execute the latter estimation correctly, phase and gain adaptation has to be applied to the data on the feedback path OS before input to "gain as function of amplitude"-adaptation.

The order of the adaptations can be changed in dependence of the stability of the system and practical implementation issues. Consequently, then, the order in which the relations are estimated must be reversed as well.

It is noted that in some cases the delay adaptation may be omitted: then only the "gain as function of amplitude"-adaptation and non-linear "phase as a function of frequency and gain as a function of frequency"-adaptation and their corresponding estimation block need to be implemented.

Also, the same principle can be used to split the phase and gain estimation and adaptation processes further in more additional frequency-related components. Once again, the order in which the adaptations may be executed can be chosen as desired.

It is further noted that the system according to the present invention is not only limited to a transmission system comprising digital predistortion of the power amplifier and frequency-dependent phase and gain adaptation. The system can be designed in such a way that a general correction of gain as a function of amplitude, delay and frequency-dependent phase and gain is feasible.

## Claims

1. Arrangement for real-time phase and gain adaptation as a function of frequency and gain adaptation as a function of amplitude of an input signal in relation to an output signal, said input signal having a first absolute phase and first power as a function of frequency, said output signal having a second absolute phase and second power as a function of frequency, said output signal, in use, being amplified relative to said input signal,
said arrangement comprising a gain correction block (2,6), a phase correction block (9,10), and a power amplifier (4),
said gain correction block (2,6) being connected at a third input (118) for receiving said input signal, further being connected in a feedback path to an input (107) of said power amplifier (4) through a first output (102) of said gain correction block (2,6), and through a second input (115) of said gain correction block (2,6) to an output (108) of said power amplifier (4);
said phase correction block (9,10) being connected at a third input (119) for receiving said input signal, said phase correction block (9,10) being connected in said feedback path to said input (107) of said power amplifier (4) through a first output (104) of said phase correction block (9, 10), and through a second input (111) of said phase correction block (9,10) to said output (108) of said power amplifier (4);
said gain correction block (2,6) being connected at a first input (100) for receiving said input signal and said phase correction block (9,10) being connected at a first input (103) to said first output (102) of said gain correction block,
said gain correction block (2,6) being arranged for receiving said input signal at said third input (118) and a gain reference signal at said second input (115) and for correcting said first power of said input signal, relative to said second power of said output signal, to form a predistorted outgoing signal and for outputting at said first output (102) said predistorted outgoing signal, said gain reference signal having a gain value identical to said second power of said output signal relative to said first power of said input signal,
**characterised in that**
said phase correction block (9,10) being arranged for receiving said input signal as represented in digital base band at said third input (119) and a phase reference signal at said second input (111) and for correcting by a representation in the frequency domain the first absolute phase of said input signal, relative to said second absolute phase of said output signal, as a function of frequency to form a phase-corrected outgoing signal and for outputting at said first output (104) said phase-corrected outgoing signal, said phase reference signal having a phase value identical to said second absolute phase of said output signal relative to said first absolute phase of said input signal,
said gain correction block (2,6) and said phase correction block (9,10) using a single feedback signal in said feedback path for deriving said gain reference signal and said phase reference signal, respectively.

2. Arrangement according to claim 1, **characterised in that** said phase correction block (9,10) comprises a second output (114) connected to said second input (115) of the gain correction block (2,6), and the phase correction block is arranged for outputting at said second output (114) a further output signal for transmission to said second input (115) of said gain correction block (2, 6) as said gain reference signal.

3. Arrangement according to any of the preceding claims, **characterised in that** said gain correction block (2,6) comprises a digital predistortion block (2) and an amplitude transfer estimation block (6),
said a digital predistortion block (2) comprising a gain control input (117), said amplitude transfer estimation block (6) comprising a gain control output (116),
said gain control output (116) being connected to said gain control input (117),
said amplitude transfer estimation block (6) being arranged for:
- receiving said gain reference signal and for receiving at said third input (118) said input signal, for comparing said input signal with said gain reference signal,
- determining a gain control signal, and
- outputting said gain control signal at said gain control output (116), said digital predistortion block (2) being arranged for:
- receiving said input signal at said first input (100) and said gain control signal at said gain control input (117), and
- correcting said first power of said input signal, relative to said second power of said output signal, as a function of amplitude, using said gain control signal.

4. Arrangement according to any of the preceding claims, **characterised in that** said phase correction block (9,10) comprises a phase adaptation block (9) and a phase estimation and correction block (10),
said phase adaptation block (9) comprising a phase control input (113), said phase estimation and correction block (10) comprising a phase control output (112),
said phase control output (112) being connected to said phase control input (113),
said phase estimation and correction block (10) being arranged for:
- receiving said phase reference signal and receiving at said third input (119) said input signal, for comparing said input signal with said phase reference signal,
- determining a phase control signal, and
- outputting said phase control signal at said phase control output (112), said phase adaptation block (9) being arranged for:
- receiving said predistorted outgoing signal at said first input (103) and said phase control signal at said phase control input (113), and
- correcting said first absolute phase of said input signal, relative to said second absolute phase of said output signal, as a function of frequency, using said phase control signal.

5. Arrangement according to claim 4, **characterised in that** said phase adaptation block (9) comprises a first digital Fourier transform processor (DFT), an inverse digital Fourier transform processor (DFT), a corrector (CRT), and an adjuster (ADJ),
said digital Fourier transform processor (DFT) being connected to a first input of said corrector (CRT), said corrector (CRT) being connected at an output to an input of said inverse digital Fourier transform processor (IDFT), said adjuster (ADJ) being connected with an output to a second input of said corrector (CRT), said digital Fourier transform processor (DFT) being arranged for receiving at an input said predistorted outgoing signal and transforming said predistorted outgoing signal as a Fourier transformed signal,
said adjuster (ADJ) being arranged for:
- receiving at said phase control input (113) said phase control signal, and at a second input a desired phase value of said phase as function of frequency and
- determining an adjuster correction signal,
said corrector being arranged for:
- receiving said Fourier transformed signal and said adjuster correction signal, and
- determining and outputting a corrected Fourier transformed signal,
said inverse digital Fourier, transform processor (IDFT) being arranged for receiving said corrected Fourier transformed signal and for determining and out- putting an inverse Fourier transform of said corrected Fourier transformed signal as said phase-corrected outgoing signal.

6. Arrangement for real-time phase and gain adaptation as a function of frequency and gain adaptation as a function of amplitude of an input signal in relation to an output signal, said input signal having a first absolute phase and first power as a function of frequency, said output, signal having a second absolute phase and second power as a function of frequency, said output signal, in use, being amplified relative to said input signal,
said arrangement comprising a gain correction block (2,6), a phase correction block (9,10), and a power amplifier (4),
said gain correction block (2,6) being connected at a third input (118) for receiving said input signal, further being connected in a feedback path to an input (107) of said power amplifier (4) through a first output (102) of said gain correction block (2,6), and through a second input (115) of said gain correction block (2,6) to an output (108) of said power amplifier (4);
said phase correction block (9, 10) being connected at a third input (119) for receiving said input signal, said phase correction block (9,10) being connected in said feedback path to said input (107) of said power amplifier (4) through a first output (104) of said phase correction block (9,10), and through a second input (111) of said phase correction block (9,10) to said output (108) of said power amplifier (4);
said phase correction block (9,10) being connected at a first input (103) for receiving said input signal and said gain correction block (2,6) being connected at a first input (100) to said first output (104) of said phasecorrection block;
said gain correction block (2,6) being arranged for receiving said input signal at said third input (118) and a gain reference signal at said second input (115) and for correcting said first power of said input signal, relative to said second power of said output signal, to form a predistorted outgoing signal and for outputting at said first output (102) said predistorted outgoing signal, said gain reference signal having a gain value identical to said second power of said output signal relative to said first power of said input signal,
**characterised in that**
said phase correction block (9,10) being arranged for receiving said input signal as represented in digital base band at said third input (119) and a phase reference signal at said second input (111) and for correcting by a representation in the frequency domain the first absolute phase of said input signal, relative to said second absolute phase of said output signal, as a function of frequency to form a phase-corrected outgoing signal and for outputting at said first output (104) said phase-corrected outgoing signal, said phase reference signal having a phase value identical to said second absolute phase of said output signal relative to said first absolute phase of said input signal,
said gain correction block (2,6) and said phase correction block (9,10) using a single feedback signal in said feedback path for deriving said gain reference signal and said phase reference signal, respectively.

7. Arrangement according to claim 6, **characterised in that** said gain correction block (2,6) comprises a second output connected to said second input (111) of the phase correction block (9,10), and the gain correction block is arranged for outputting at said second output a further output signal for transmission to said second input (111) of said phase correction block (9, 10) as said phase reference signal.

8. Arrangement according to claim 6 or 7, **characterised in, that** said gain correction block (2,6) comprises a digital predistortion block (2) and an amplitude transfer estimation block (6),
said a digital predistortion block (2) comprising a gain control input (117), said amplitude transfer estimation block (6) comprising a gain control output (116),
said gain control output (116) being connected to said gain control input (117),
said amplitude transfer estimation block (6) being arranged for:
- receiving said gain reference signal and for receiving at said third input (118) said input signal, for comparing said input signal with said gain reference signal,
- determining a gain control signal, and
- outputting said gain control signal at said gain control output (116), said digital predistortion block (2) being arranged for:
- receiving said phase-corrected outgoing signal at said first input (100) and said gain control signal at said gain control input (117), and
- correcting said first power of said input signal, relative to said second power of said output signal, as a function of amplitude, using said gain control signal.

9. Arrangement according to any of the preceding claims 6-8, **characterised in that** said phase correction block (9,10) comprises a phase adaptation block (9) and a phase estimation and correction block (10),
said phase adaptation block (9) comprising a phase control input (113), said phase estimation and correction block (10) comprising a phase control output (112),
said phase control output (112) being connected to said phase control input (113),
said phase estimation and correction block (10) being arranged for:
- receiving said phase reference signal and receiving at said third input (119) said input signal, for comparing said input signal with said phase reference signal,
- determining a phase control signal, and
- outputting said phase control signal at said phase control output (112), said phase adaptation block (9) being arranged for:
- receiving said input signal at said first input (103) and said phase control signal at said phase control input (113),
and
- correcting said first absolute phase of said input signal, relative to said second absolute phase of said output signal, as a function of frequency, using said phase control signal.

10. Arrangement according to claim 9, **characterised in that** said phase adaptation block (9) comprises a first digital Fourier transform processor (DFT), an inverse digital Fourier transform processor (IDFT), a corrector (CRT), and an adjuster (ADJ),
said digital Fourier transform processor (DFT) being connected to a first input of said corrector (CRT), said corrector (CRT) being connected at an output to an input of said inverse digital Fourier, transform processor (IDFT), said adjuster (ADJ) being connected with an output to a second input of said corrector (CRT), said digital Fourier transform processor (DFT) being arranged for receiving at an input said input signal and transforming said input signal as a Fourier transformed signal,
said adjuster (ADJ) being arranged for:
- receiving at said phase control input (113) said phase control signal, and at a second input a desired phase value of said phase as function of frequency and
- determining an adjuster correction signal,
said corrector being arranged for:
- receiving said Fourier transformed signal and said adjuster correction signal, and
- determining and outputting a corrected Fourier transformed signal,
said inverse digital Fourier transform processor (IDFT) being arranged for receiving said corrected Fourier transformed signal and for determining and out- putting an inverse Fourier transform of said corrected Fourier transformed signal as said phase-corrected outgoing signal.

11. Arrangement according to any one of the preceding claims, **characterised in that** said input of said power amplifier (4) comprises a digital-analogue- and up- converter (3), and the output of said power amplifier (4) comprises an analogue-digital and down-converter (5),
wherein said digital-analogue-and up-converter (3) is arranged in said feedback path between both said first outputs (102, 104) of said gain correction block (2,6) and said phase correction block (9, 10) and said input (107) of said power amplifier (4), and said analogue-digital and down-converter (5) is arranged in said feedback path between said output (108) of said power amplifier (4) and both said second inputs (111, 115) of said phase correction block (9, 10) and said gain correction block (2,6).

12. Arrangement according to 4 or 7, **characterised in that** said phase estimation and correction block (10) comprises a cross-correlator (XC), a temporal processor (TP), a second digital Fourier transform processor (DFT2), and a spectral processor (SP),
said cross-correlator XC being connected at an output to an input of said temporal processor (TP), said temporal processor (TP) being connected at an output to an input of said second digital Fourier transform processor (DFT2), said second digital Fourier transform processor (DFT2) being connected at an output to an input of said spectral processor (SP), said spectral processor SP having said phase control output (112),
said cross-correlator (XC) being arranged for:
- receiving on said third input (119) said input signal and on said second input (111) said phase reference signal,
- determining, synchronising and cross-correlating said input signal and said phase reference signal into a cross-correlated signal, and
- outputting said cross-correlated signal to said temporal processor (TP), said temporal processor (TP) being arranged for:
- receiving said cross-correlated signal from said cross-correlator (XC),
- adapting said cross-correlated signal into a modified cross-correlated signal adapted for a Fourier transform, and
- outputting said modified cross-correlated signal to said second digital Fourier transform processor (DFT2),
said digital Fourier transform processor (DFT2) being arranged for:
- receiving said modified cross-correlated signal,
- computing a power spectrum signal from said modified cross-correlated signal, and
- outputting said power spectrum signal to said spectral processor (SP), said spectral processor (SP) being arranged for:
- receiving said power spectrum signal,
- determining at least an estimate of a phase as a function of frequency from said power spectrum signal as a phase-frequency signal, and
- outputting said phase-frequency signal as said phase control signal to said phase adaptation block (9).

13. Method to be carried out by an arrangement as defined in claim 1, for real-time phase and gain adaptation as a function of frequency and gain adaptation as a function of amplitude of an input signal in relation to an output signal, said input signal having a first absolute phase and first power as a function of frequency, said output signal having a second absolute phase and second power as a function of frequency, said output signal, in use, being amplified relative to said input signal,
said method comprising a gain correction and a phase correction;
said gain correction comprising :
- receiving said input signal as represented in digital base band and a gain reference signal from a feedback path,
- correcting said first power of said input signal, relative to said second power of said output signal, into a predistorted outgoing signal, and
- outputting said predistorted outgoing signal, said gain reference signal having a gain value identical to said second power of said output signal relative to said first power of said input signal,
wherein
said method comprises a phase correction;
said phase correction comprising:
- receiving said predistorted outgoing signal, said input signal and a phase reference signal from said feedback path,
- determining a phase control signal on the basis of said first absolute phase of said input signal, relative to said second absolute phase of said output signal, as a function of frequency,
- correcting said predistorted outgoing signal by a representation in the frequency domain on the basis of the phase control signal, into a phase-corrected outgoing signal,
and
- outputting said phase-corrected outgoing signal, said phase reference signal having a phase value identical to said second absolute phase of said output signal relative to said first absolute phase of said input signal, wherein said gain correction and said phase correction are using a single feedback signal in said feedback path for deriving said gain reference signal and said phase reference signal, respectively.

14. Method to be carried out by an arrangement as defined in claim 6, for real-time phase and gain adaptation as a function of frequency and gain adaptation as a function of amplitude of an input signal in relation to an output signal, said input signal having a first absolute phase and first power as a function of frequency, said output signal having a second absolute phase and second power as a function of frequency, said output signal, in use, being amplified relative to said input signal,
said method comprising a gain correction and a phase correction;
said phase correction comprising:
- receiving said input signal as represented in digital base band and a phase reference signal from said feedback path,
- correcting by a representation in the frequency domain said first absolute phase of said input signal, relative to said second absolute phase of said output signal, as a function of frequency into a phase-corrected outgoing signal, and
- outputting said phase-corrected outgoing signal, said phase reference signal having a phase value identical to said second absolute phase of said output signal relative to said first absolute phase of said input signal,
said gain correction comprising :
- receiving said phase-corrected outgoing signal, said input signal and a gain reference signal from a feedback path,
- determining a gain control signal on the basis of said first power of said input signal, relative to said second power of said output signal,
- correcting said phase-corrected outgoing signal on the basis of said gain control signal into a predistorted outgoing signal, and
- outputting said predistorted outgoing signal, said gain reference signal having a gain value identical to said second power of said output signal relative to said first power of said input signal,
wherein said gain correction and said phase correction are using a single feedback signal in said feedback path for deriving said gain reference signal and said phase reference signal, respectively.

15. Computer program product to be loaded by an arrangement as defined in claim 1, said computer program product when executed performing real-time phase and gain adaptation as a function of frequency and gain adaptation as a function of amplitude of an input signal in relation to an output signal, said input signal having a first absolute phase and first power as a function of frequency, said output signal having a second absolute phase and second power as a function of frequency, said output signal, in use, being amplified relative to said input signal, including a gain correction and a phase correction;
said gain correction comprising:
- receiving said input signal as represented in digital base band and a gain reference signal from a feedback path,
- correcting said first power of said input signal, relative to said second power of said output signal, as a function of frequency into a predistorted outgoing signal, and
- outputting said predistorted outgoing signal, said gain reference signal having a gain value identical to said second power of said output signal relative to said first power of said input signal;;
said phase correction comprising:
- receiving said predistorted outgoing signal, said input signal and a phase reference signal from said feedback path,
- determining a phase control signal on the basis of said first absolute phase of said input signal, relative to said second absolute phase of said output signal, as a function of frequency,
- correcting said predistorted outgoing signal by a representation in the frequency domain on the basis of the phase control signal, into a phase-corrected outgoing signal, and
- outputting said phase-corrected outgoing signal, said phase reference signal having a phase value identical to said second absolute phase of said output signal relative to said first absolute phase of said input signal;
wherein said gain correction and said phase correction are using a single feedback signal in said feedback path for deriving said gain reference signal and said phase reference signal, respectively.

16. Computer program product to be loaded by an arrangement as defined in claim 6, said computer program product when executed performing real-time phase and gain adaptation as a function of frequency and gain adaptation as a function of amplitude of an input signal in relation to an output signal, said input signal having a first absolute phase and first power as a function of frequency, said output signal having a second absolute phase and second power as a function of frequency, said output signal, in use, being amplified relative to said input signal, including a gain correction and a phase correction,
said phase correction comprising:
- receiving said input signal, said input signal as represented in digital base band and a phase reference signal from said feedback path,
- correcting by a representation in the frequency domain said first absolute phase of said input signal, relative to said second absolute phase of said output signal, as a function of frequency into a phase-corrected outgoing signal, and
- outputting said phase-corrected outgoing signal, said phase reference signal having a phase value identical to said second absolute phase of said output signal relative to said first absolute phase of said input signal;
said gain correction comprising:
- receiving said phase-corrected outgoing signal, said input signal and a gain reference signal from said feedback path,
- determining a gain control signal on the basis of said first power of said input signal, relative to said second power of said output signal,
- correcting said phase-corrected outgoing signal on the basis of said gain control signal into a predistorted outgoing signal, and
- outputting said predistorted outgoing signal, said gain reference signal having a gain value identical to said second power of said output signal relative to said first power of said input signal,
wherein said gain correction and said phase correction are using a single feedback signal in said feedback path for deriving said gain reference signal and said phase reference signal, respectively.

17. Data carrier with a computer program product as claimed in claim 15 or 16.

## Patentansprüche

1. Anordnung zur frequenzabhängigen Phasen- und Verstärkungsanpassung und zur amplitudenabhängigen Verstärkungsanpassung in Echtzeit eines Eingangssignals in Bezug auf ein Ausgangssignal, wobei das Eingangssignal eine frequenzabhängige erste absolute Phase und eine erste Leistung hat, das Ausgangssignal eine frequenzabhängige zweite absolute Phase und eine zweite Leistung hat, wobei das Ausgangssignal bei Verwendung in Bezug auf das Eingangssignal verstärkt wird,
wobei die Anordnung einen Verstärkungskorrekturblock (2,6), einen Phasenkorrekturblock (9,10) und einen Leistungsverstärker (4) umfasst,
wobei der Verstärkungskorrekturblock (2,6) an einem dritten Eingang (118) zum Empfangen des Eingangssignals verbunden ist, ferner in einem Rückkopplungspfad mit einem Eingang (107) des Leistungsverstärkers (4) durch einen ersten Ausgang (102) des Verstärkungskorrekturblocks (2,6) und durch einen zweiten Eingang (115) des Verstärkungskorrekturblocks (2,6) mit einem Ausgang (108) des Leistungsverstärkers (4) verbunden ist;
wobei der Phasenkorrekturblock (9,10) an einem dritten Eingang (119) zum Empfangen des Eingangssignals verbunden ist, der Phasenkorrekturblock (9,10) in dem Rückkopplungspfad mit dem Eingang (107) des Leistungsverstärkers (4) durch einen ersten Ausgang (104) des Phasenkorrekturblocks (9,10) und durch einen zweiten Eingang (111) des Phasenkorrekturblocks (9,10) mit dem Ausgang (108) des Leistungsverstärkers (4) verbunden ist;
wobei der Verstärkungskorrekturblock (2,6) an einem ersten Eingang (100) zum Empfangen des Eingangssignals verbunden ist und der Phasenkorrekturblock (9,10) an einem ersten Eingang (103) mit dem ersten Ausgang (102) des Verstärkungskorrekturblocks verbunden ist,
wobei der Verstärkungskorrekturblock (2,6) angeordnet ist, um das Eingangssignal an dem dritten Eingang (118) und ein Verstärkungsreferenzsignal an dem zweiten Eingang (115) zu empfangen und um die erste Leistung des Eingangssignals in Bezug auf die zweite Leistung des Ausgangssignals zu korrigieren, um ein vorverzerrtes ausgehendes Signal zu bilden, und um am ersten Ausgang (102) das vorverzerrte ausgehende Signal auszugeben, wobei das Verstärkungsreferenzsignal einen Verstärkungswert aufweist, der mit der zweiten Leistung des Ausgangssignals in Bezug auf die erste Leistung des Eingangssignals identisch ist,
**dadurch gekennzeichnet, dass**
der Phasenkorrekturblock (9,10) angeordnet ist, um das Eingangssignal wie im digitalen Basisband dargestellt an dem dritten Eingang (119) und ein Phasenreferenzsignal an dem zweiten Eingang (111) zu empfangen und durch eine Darstellung in der Frequenzdomäne die erste absolute Phase des Eingangssignals in Bezug auf die zweite absolute Phase des Ausgangssignals in Abhängigkeit von der Frequenz zu korrigieren, um ein phasenkorrigiertes ausgehendes Signal zu bilden, und um an dem ersten Ausgang (104) das phasenkorrigierte ausgehende Signal auszugeben, wobei das Phasenreferenzsignal einen Phasenwert aufweist, der zu der zweiten absoluten Phase des Ausgangssignals in Bezug auf die erste absolute Phase des Eingangssignals identisch ist, wobei
der Verstärkungskorrekturblock (2,6) und der Phasenkorrekturblock (9,10) ein einzelnes Rückkopplungssignal in dem Rückkopplungspfad zum Ableiten des Verstärkungsreferenzsignals bzw. des Phasenreferenzsignals verwenden.

2. Anordnung nach Anspruch 1, **dadurch gekennzeichnet, dass** der Phasenkorrekturblock (9,10) einen zweiten Ausgang (114), der mit dem zweiten Eingang (115) des Verstärkungskorrekturblocks (2,6) verbunden ist, umfasst, und der Phasenkorrekturblock angeordnet ist, um an dem zweiten Ausgang (114) ein weiteres Ausgangssignal zum Übertragen an den zweiten Eingang (115) des Verstärkungskorrekturblocks (2,6) als das Verstärkungsreferenzsignal auszugeben.

3. Anordnung nach einem der vorhergehenden Ansprüche, **dadurch gekennzeichnet, dass** der Verstärkungskorrekturblock (2,6) einen digitalen Vorverzerrungsblock (2) und einen Amplitudentransferschätzungsblock (6) umfasst, wobei der digitale Vorverzerrungsblock (2) einen Verstärkungssteuereingang (117) umfasst, der Verstärkungstransferschätzungsblock (6) einen Verstärkungssteuerausgang (116) umfasst,
der Verstärkungssteuerausgang (116) mit dem Verstärkungssteuereingang (117) verbunden ist,
der Amplitudentransferschätzungsblock (6) angeordnet ist, um:
- das Verstärkungsreferenzsignal zu empfangen und an dem dritten Eingang (118) das Eingangssignal zu empfangen, um das Eingangssignal mit dem Verstärkungsreferenzsignal zu vergleichen,
- ein Verstärkungssteuersignal zu bestimmen, und
- das Verstärkungssteuersignal an dem Verstärkungssteuerausgang (116) auszugeben, wobei
der digitale Vorverzerrungsblock (2) angeordnet ist, um:
- das Eingangssignal an dem ersten Eingang (100) und das Verstärkungssteuersignal an dem Verstärkungssteuereingang (117) zu empfangen, und
- die erste Leistung des Eingangssignals in Bezug auf die zweite Leistung des Eingangssignals in Abhängigkeit von der Amplitude unter Verwendung des Verstärkungssteuersignals zu korrigieren.

4. Anordnung nach einem der vorhergehenden Ansprüche, **dadurch gekennzeichnet, dass** der Phasenkorrekturblock (9, 10) einen Phasenanpassungsblock (9) und einen Phasenschätzungs- und -korrekturblock (10) umfasst,
der Phasenanpassungsblock (9) einen Phasensteuereingang (113) umfasst,
der Phasenschätzungs- und -korrekturblock (10) einen Phasensteuerausgang (112) umfasst,
der Phasensteuerausgang (112) mit dem Phasensteuereingang (113) verbunden ist,
der Phasenschätzungs- und -korrekturblock (10) angeordnet ist, um:
- das Phasenreferenzsignal zu empfangen und an dem dritten Eingang (119) das Eingangssignal zu empfangen, um das Eingangssignal mit dem Phasenreferenzsignal zu vergleichen,
- ein Phasensteuersignal zu bestimmen, und
- das Phasensteuersignal an dem Phasensteuerausgang (112) auszugeben, wobei
der Phasenanpassungsblock (9) angeordnet ist, um:
- das vorverzerrte Ausgangssignal an dem ersten Eingang (103) und das Phasensteuersignal an dem Phasensteuereingang (113) zu empfangen, und
- die erste absolute Phase des Eingangssignals in Bezug auf die zweite absolute Phase des Ausgangssignals in Abhängigkeit von der Frequenz unter Verwendung des Phasensteuersignals zu korrigieren.

5. Anordnung nach Anspruch 4, **dadurch gekennzeichnet, dass** der Phasenanpassungsblock(9) einen ersten digitalen Fourier-Transformationsprozessor (DFT), einen inversen digitalen Fourier-Transformationsprozessor (IDFT), einen Corrector (CRT) und einen Adjuster (ADJ) umfasst,
der digitale Fourier Transformationsprozessor (DFT) mit einem ersten Eingang des Correctors (CRT) verbunden ist, der Corrector (CRT) an einem Ausgang mit einem Eingang des inversen digitalen Fourier-Transformationsprozessor (IDFT) verbunden ist, der Adjuster (ADJ) mit einem Ausgang mit einem zweiten Eingang des Correctors (CRT) verbunden ist, der digitale Fourier-Transformationsprozessor (DFT) angeordnet ist, um an einem Eingang das vorverzerrte Ausgangssignal zu empfangen und das vorverzerrte Ausgangssignal als ein Fourier-transformiertes Signal zu transformieren,
der Adjuster (ADJ) angeordnet ist, um:
- an dem Phasensteuereingang (113) das Phasensteuersignal und an einem zweiten Eingang einen erwünschten Phasenwert der Phase in Abhängigkeit von der Frequenz zu empfangen, und
- ein Adjuster-Korrektursignal zu bestimmen,
der Corrector angeordnet ist, um:
- das Fourier-transformierte Signal und das Adjuster-Korrektursignal zu empfangen, und
- ein korrigiertes Fourier-transformiertes Signal zu bestimmen und auszugeben,
der inverse digitale Fourier-Transformationsprozessor (IDFT) angeordnet ist, um das korrigierte Fourier-transformierte Signal zu empfangen und eine inverse Fourier-Transformation des korrigierten Fouriertransformierten Signals als das phasenkorrigierte Ausgangssignal auszugeben.

6. Anordnung zur frequenzabhängigen Phasen- und
- verstärkungsanpassung und zur amplitudenabhängigen Verstärkungsanpassung in Echtzeit eines Eingangssignals in Bezug auf ein Ausgangssignal, wobei das Eingangssignal eine frequenzabhängige erste absolute Phase und erste Leistung hat, das Ausgangssignal eine frequenzabhängige zweite absolute Phase und zweite Leistung hat, das Ausgangssignal bei Verwendung in Bezug auf das Eingangssignal verstärkt wird,
wobei die Anordnung einen Verstärkungskorrekturblock (2,6), einen Phasenkorrekturblock (9,10) und einen Leistungsverstärker (4) umfasst,
der Verstärkungskorrekturblock (2,6) mit einem dritten Eingang (118) zum Empfang des Eingangssignals verbunden ist, ferner in einem Rückkopplungspfad mit einem Eingang (107) des Leistungsverstärkers (4) durch einen ersten Ausgang (102) des Verstärkungskorrekturblocks (2,6) und durch einen zweiten Eingang (115) des Verstärkungskorrekturblocks (2,6) mit einem Ausgang (108) des Leistungsverstärkers (4) verbunden ist;
der Phasenkorrekturblock (9,10) an einem dritten Eingang (119) zum Empfang des Eingangssignals verbunden ist, der Phasenkorrekturblock (9,10) in dem Rückkopplungspfad mit dem Eingang (107) des Leistungsverstärkers (4) durch einen ersten Ausgang (104) des Phasenkorrekturblocks (9,10) und durch einen zweiten Eingang (111) des Phasenkorrekturblocks (9,10) mit dem Ausgang (108) des Leistungsverstärkers (4) verbunden ist;
der Phasenkorrekturblock (9,10) an einem ersten Eingang (103) zum Empfang des Eingangssignals verbunden ist und der Verstärkungskorrekturblock (2,6) an einem ersten Eingang (100) mit dem ersten Ausgang (104) des Phasenkorrekturblocks verbunden ist;
der Verstärkungskorrekturblock (2,6) angeordnet ist zum Empfang des Eingangssignals an dem dritten Eingang (118) und eines Verstärkungsreferenzsignals an dem zweiten Eingang (115) und zur Korrektur der ersten Leistung des Eingangssignals in Bezug auf die zweite Leistung des Ausgangssignals, um ein vorverzerrtes Ausgangssignal zu bilden und das vorverzerrte Ausgangssignal an dem ersten Ausgang (102) auszugeben, wobei das Verstärkungsreferenzsignal einen Verstärkungswert hat, der mit der zweiten Leistung des Ausgangssignals in Bezug auf die erste Leistung des Eingangssignals identisch ist,
**dadurch gekennzeichnet, dass**
der Phasenkorrekturblock (9,10) angeordnet ist zum Empfang des Eingangssignals, wie dargestellt im digitalen Basisband, an dem dritten Eingang (119) und eines Phasenreferenzsignals an dem zweiten Eingang (111) und zur Korrektur der ersten absoluten Phase des Eingangssignals in Bezug auf die zweite absolute Phase des Ausgangssignals in Abhängigkeit von der Frequenz durch eine Darstellung in der Frequenzdomäne, um ein phasenkorrigiertes Ausgangssignal zu bilden und an dem ersten Ausgang (104) das phasenkorrigierte Ausgangssignal auszugeben, wobei das Phasenreferenzsignal einen Phasenwert hat, der mit der zweiten absoluten Phase des Ausgangssignals in Bezug auf die erste absolute Phase des Eingangssignals identisch ist,
der Verstärkungskorrekturblock (2,6) und der Phasenkorrekturblock (9,10) ein einzelnes Signal in dem Rückkopplungspfad verwenden, um das Verstärkungsreferenzsignal bzw. das Phasenreferenzsignal abzuleiten.

7. Anordnung nach Anspruch 6, **dadurch gekennzeichnet, dass** der Verstärkungskorrekturblock (2,6) einen zweiten Ausgang umfasst, der mit dem zweiten Eingang (111) des Phasenkorrekturblocks (9,10) verbunden ist, und der Verstärkungskorrekturblock angeordnet ist, um an dem zweiten Ausgang ein weiteres Ausgangssignal zur Übertragung an den zweiten Eingang (111) des Phasenkorrekturblocks (9,10) als das Phasenreferenzsignal auszugeben.

8. Anordnung nach Anspruch 6 oder 7, **dadurch gekennzeichnet, dass** der Verstärkungskorrekturblock (2,6) einen digitalen Vorverzerrungsblock (2) und einen Amplitudentransferschätzungsblock (6) umfasst,
der digitale Vorverzerrungsblock (2) einen Verstärkungssteuereingang (117) umfasst, der Amplitudentransferschätzungsblock (6) einen Verstärkungssteuerausgang (116) umfasst,
der Verstärkungssteuerausgang (116) mit dem
Verstärkungssteuereingang (117) verbunden ist;
der Amplitudentransferschätzungsblock (6) angeordnet ist, um:
- das Verstärkungsreferenzsignal zu empfangen und an dem dritten Eingang (118) das Eingangssignal zu empfangen, um das Eingangssignal mit dem Verstärkungsreferenzsignal zu vergleichen,
- ein Verstärkungssteuersignal zu bestimmen, und
- das Verstärkungssteuersignal an dem Verstärkungssteuerausgang (116) auszugeben,
der digitale Vorverzerrungsblock (2) angeordnet ist, um:
- das phasenkorrigierte Ausgangssignal an dem ersten Eingang (100) und das Verstärkungssteuersignal an dem Verstärkungssteuereingang (117) zu empfangen, und
- die erste Leistung des Eingangssignals in Bezug auf die zweite Leistung des Ausgangssignals unter Verwendung des Verstärkungssteuersignals amplitudenabhängig zu korrigieren.

9. Anordnung nach einem der vorhergehenden Ansprüche 6-8, **dadurch gekennzeichnet, dass** der Phasenkorrekturblock (9,10) einen Phasenanpassungsblock (9) und einen Phasenschätzungs- und -korrekturblock (10) umfasst,
der Phasenanpassungsblock (9) einen Phasensteuereingang (113) umfasst,
der Phasenschätzungs- und -korrekturblock (10) einen Phasensteuerausgang (112) umfasst,
der Phasensteuerausgang (112) mit dem Phasensteuereingang (113) verbunden ist,
der Phasenschätzungs- und -korrekturblock (10) angeordnet ist, um:
- das Phasenreferenzsignal zu empfangen und an dem dritten Eingang (119) das Eingangssignal zu empfangen, um das Eingangssignal mit dem Phasenreferenzsignal zu vergleichen,
- ein Phasensteuersignal zu bestimmen, und
- das Phasensteuersignal an dem Phasensteuerausgang (112) auszugeben,
der Phasenanpassungsblock (9) angeordnet ist, um:
- das Eingangssignal an dem ersten Eingang (103) und das Phasensteuersignal an dem Phasensteuereingang (113) zu empfangen,
und
- die erste absolute Phase des Eingangssignals in Bezug auf die zweite absolute Phase des Ausgangssignals frequenzabhängig unter Verwendung des Phasensteuersignals zu korrigieren.

10. Anordnung nach Anspruch 9, **dadurch gekennzeichnet, dass** der Phasenanpassungsblock (9) einen ersten digitalen Fourier-Transformationsprozessor (DFT), einen inversen digitalen Fourier-Transformationsprozessor (IDFT), einen Corrector (CRT) und einen Adjuster (ADJ) umfasst,
der digitale Fourier-Transformationsprozessor (DFT) mit einem ersten Eingang des Correctors (CRT) verbunden ist, der Corrector (CRT) an einem Ausgang mit einem Eingang des inversen digitalen Fourier-Transformationsprozessors (IDFT) verbunden ist, der Adjuster (ADJ) mit einem Ausgang an einem zweiten Eingang des Correctors (CRT) verbunden ist, der digitale Fourier-Transformationsprozessor (DFT) angeordnet ist, um an einem Eingang das Eingangssignal zu empfangen und das Eingangssignal als ein Fourier-transformiertes Signal zu transformieren,
der Adjuster (ADJ) angeordnet ist, um:
- an dem Phasensteuereingang (113) das Phasensteuersignal und an einem zweiten Eingang einen erwünschten Phasenwert der Phase abhängig von der Frequenz zu empfangen, und
- ein Adjuster-Korrektursignal zu bestimmen,
der Corrector angeordnet ist, um:
- das Fourier-transformierte Signal und das Adjuster-Korrektursignal zu empfangen, und
- ein korrigiertes Fourier-transformiertes Signal zu bestimmen und auszugeben,
der inverse digitale Fourier-Transformationsprozessor (IDFT) angeordnet ist, um das korrigierte Fourier-transformierte Signal zu empfangen und eine inverse Fourier-Transformation des korrigierten Fouriertransformierten Signals als das phasenkorrigierte Ausgangssignal auszugeben.

11. Anordnung nach einem der vorhergehenden Ansprüche, **dadurch gekennzeichnet, dass** der Eingang des Leistungsverstärkers (4) einen Digital-Analog- und Aufwärts-Frequenzumsetzer (3) umfasst und der Ausgang des Leistungsverstärkers (4) einen Analog-Digital-Abwärts-Frequenzumsetzer (5) umfasst,
der Digital-Analog- und Aufwärtsfrequenzumsetzer (3) in dem Rückkopplungspfad zwischen den ersten Ausgängen (102, 104) des Verstärkungskorrekturblocks (2,6) und dem Phasenkorrekturblock (9,10) und dem Eingang (107) des Leistungsverstärkers (4) angeordnet ist und der Analog-Digital- und Abwärts-Frequenzumrichter (5) in dem Rückkopplungspfad zwischen dem Ausgang (108) des Leistungsverstärkers (4) und den beiden zweiten Eingängen (111, 115) des Phasenkorrekturblocks (9,10) und dem Verstärkungskorrekturblock (2,6) angeordnet ist.

12. Anordnung nach Anspruch 4 oder 7, **dadurch gekennzeichnet, dass** der Phasenschätzungs- und -korrekturblock (10) einen Kreuzkorrelator (XC), einen Temporalprozessor (TP), einen zweiten digitalen Fourier-Transformationsprozessor (DFT2) und einen Spektralprozessor (SP) umfasst,
der Kreuzkorrelator (XC) an einem Ausgang mit einem Eingang des Temporalprozessors (TP) verbunden ist, der Temporalprozessor (TP) an einem Ausgang mit einem Eingang des zweiten digitalen Fourier-Transformationsprozessors (DFT2) verbunden ist, der zweite digitale Fourier-Transformationsprozessor an einem Ausgang mit einem Eingang des Spektralprozessors (SP) verbunden ist, der Spektralprozessor SP den Phasensteuerausgang (112) hat,
der Kreuzkorrelator (XC) angeordnet ist, um:
- an dem dritten Eingang (119) das Eingangssignal und an dem zweiten Eingang (111) das Phasenreferenzsignal zu empfangen,
- das Eingangssignal und das Phasenreferenzsignal zu einem kreuzkorrelierten Signal zu bestimmen, zu synchronisieren und zu kreuzkorrelieren, und
- das kreuzkorrelierte Signal zu dem Temporalprozessor (TP) auszugeben,
der Temporalprozessor (TP) angeordnet ist, um:
- das kreuzkorrelierte Signal von dem Kreuzkorrelator (XC) zu empfangen,
- das kreuzkorrelierte Signal zu einem modifizierten kreuzkorrelierten Signal, angepasst für eine Fourier-Transformation, anzupassen, und
- das modifizierte kreuzkorrelierte Signal zu dem zweiten digitalen Fourier-Transformationsprozessor (DFT2) auszugeben,
der digitale Fourier-Transformationsprozessor (DFT2) angeordnet ist, um:
- das modifizierte kreuzkorrelierte Signal zu empfangen,
- ein Leistungsspektrumsignal von dem modifizierten kreuzkorrelierten Signal zu berechnen, und
- das Leistungsspektrumsignal an den Spektralprozessor (SP) auszugeben,
der Spektralprozessor (SP) angeordnet ist, um:
- das Leistungsspektrumsignal zu empfangen,
- mindestens eine Schätzung einer Phase in Abhängigkeit von der Frequenz von dem Leistungsspektrumsignal als ein Phase-Frequenz-Signal zu bestimmen, und
- das Phase-Frequenz-Signal als das Phasensteuersignal an den Phasenanpassungsblock (9) auszugeben.

13. Verfahren, auszuführen durch eine Anordnung nach Anspruch 1, zur frequenzabhängigen Phasen- und Verstärkungsanpassung und zur amplitudenabhängigen Verstärkungsanpassung in Echtzeit eines Eingangssignals in Bezug auf ein Ausgangssignal, wobei das Eingangssignal eine erste absolute Phase und eine erste Leistung abhängig von der Frequenz hat, das Ausgangssignal eine zweite absolute Phase und eine zweite Leistung abhängig von der Frequenz hat, und das Ausgangssignal bei Verwendung in Bezug auf das Eingangssignal verstärkt wird, wobei
das Verfahren eine Verstärkungskorrektur und eine Phasenkorrektur umfasst;
die Verstärkungskorrektur Folgendes umfasst:
- Empfangen des Eingangssignals, wie dargestellt im digitalen Basisband, und eines Verstärkungsreferenzsignals von einem Rückkopplungspfad,
- Korrektur der ersten Leistung des Eingangssignals in Bezug auf die zweite Leistung des Ausgangssignals zu einem vorverzerrten ausgehenden Signal, und
- die Ausgabe des vorverzerrten ausgehenden Signals, des Verstärkungsreferenzsignals mit einem Verstärkungswert, identisch mit der zweiten Leistung des Ausgangssignals in Bezug auf die erste Leistung des Eingangssignals,
wobei
das Verfahren eine Phasenkorrektur umfasst;
die Phasenkorrektur Folgendes umfasst:
- Empfangen des vorverzerren ausgehenden Signals, des Eingangssignals und eines Phasenreferenzsignals von dem Rückkopplungspfad,
- Bestimmen eines Phasensteuersignals auf der Basis der ersten absoluten Phase des Eingangssignals in Bezug auf die zweite absolute Phase des Ausgangssignals in Abhängigkeit von der Frequenz,
- Korrigieren des vorverzerrten Ausgangssignals durch eine Darstellung in der Frequenzdomäne auf der Basis des Phasensteuersignals in ein phasenkorrigiertes ausgehendes Signal,
und
- Ausgeben des phasenkorrigierten ausgehenden Signals, des Phasenreferenzsignals mit einem Phasenwert, identisch mit der zweiten absoluten Phase des Ausgangssignals in Bezug auf die erste absolute Phase des Eingangssignals,
wobei die Verstärkungskorrektur und die Phasenkorrektur ein einzelnes Rückkopplungssignal in dem Rückkopplungspfad zur Ableitung des Verstärkungsreferenzsignals bzw. des Phasenreferenzsignals verwenden.

14. Verfahren, auszuführen durch eine Anordnung nach Anspruch 6, zur frequenzabhängigen Phasen- und Verstärkungsanpassung und zur amplitudenabhängigen Verstärkungsanpassung in Echtzeit eines Eingangssignals in Bezug auf ein Ausgangssignal, wobei das Eingangssignal eine erste absolute Phase und eine erste Leistung abhängig von der Frequenz hat, das Ausgangssignal eine zweite absolute Phase und eine zweite Leistung abhängig von der Frequenz hat, und das Ausgangssignal bei Verwendung in Bezug auf das Eingangssignal verstärkt wird, wobei
das Verfahren eine Verstärkungskorrektur und eine Phasenkorrektur umfasst;
die Phasenkorrektur Folgendes umfasst:
- Empfangen des Eingangssignals, wie dargestellt im digitalen Basisband, und eines Phasenreferenzsignals von dem Rückkopplungspfad,
- Korrigieren durch eine Darstellung in der Frequenzdomäne der ersten absoluten Phase des Eingangssignals in Bezug auf die zweite absolute Phase des Ausgangssignals in Abhängigkeit von der Frequenz in ein phasenkorrigiertes ausgehendes Signal, und
- Ausgeben des phasenkorrigierten ausgehenden Signals, des Phasenreferenzsignals mit einem Phasenwert, identisch mit der zweiten absoluten Phase des Ausgangssignals in Bezug auf die erste absolute Phase des Eingangssignals,
die Verstärkungskorrektur Folgendes umfasst:
- Empfangen des phasenkorrigierten ausgehenden Signals, des Eingangssignals und eines Verstärkungsreferenzsignals von einem Rückkopplungspfad,
- Bestimmen eines Verstärkungssteuersignals auf der Basis der ersten Leistung des Eingangssignals in Bezug auf die zweite Leistung des Ausgangssignals,
- Korrigieren des phasenkorrigierten ausgehenden Signals auf der Basis des Verstärkungssteuersignals in ein vorverzerrtes ausgehendes Signal, und
- Ausgeben des vorverzerrten ausgehenden Signals, des Verstärkungsreferenzsignals mit einem Verstärkungswert, identisch mit der zweiten Leistung des Ausgangssignals in Bezug auf die erste Leistung des Eingangssignals,
wobei die Verstärkungskorrektur und die Phasenkorrektur ein einzelnes Rückkopplungssignal in dem Rückkopplungspfad zur Ableitung des Verstärkungsreferenzsignals bzw. des Phasenreferenzsignals verwenden.

15. Computerprogrammprodukt, zu laden durch eine Anordnung nach Anspruch 1, welches Computerprogramm bei Ausführung eine frequenzabhängige Phasen- und Verstärkungsanpassung und eine amplitudenabhängige Verstärkungsanpassung in Echtzeit eines Eingangssignals in Bezug auf ein Ausgangssignal durchführt, wobei das Eingangssignal eine erste absolute Phase und eine erste Leistung in Abhängigkeit von der Frequenz hat, das Ausgangssignal eine zweite absolute Phase und eine zweite Leistung in Abhängigkeit von der Frequenz hat, das Ausgangssignal bei Verwendung in Bezug auf das Eingangssignal verstärkt wird, einschließlich einer Verstärkungskorrektur und einer Phasenkorrektur;
die Verstärkungskorrektur Folgendes umfasst:
- Empfangen des Eingangssignals, wie dargestellt im digitalen Basisband, und eines Verstärkungsreferenzsignals von einem Rückkopplungspfad,
- Korrigieren der ersten Leistung des Eingangssignals in Bezug auf die zweite Leistung des Ausgangssignals in Abhängigkeit von der Frequenz in ein vorverzerrtes ausgehendes Signal, und
- Ausgeben des vorverzerrten ausgehenden Signals, des Verstärkungsreferenzsignals mit einem Verstärkungswert, identisch mit der zweiten Leistung des Ausgangssignals in Bezug auf die erste Leistung des Eingangssignals;
die Phasenkorrektur Folgendes umfasst:
- Empfangen des vorverzerrten ausgehenden Signals, des Eingangssignals und eines Phasenreferenzsignals von dem Rückkopplungspfad,
- Bestimmen eines Phasensteuersignals auf der Basis der ersten absoluten Phase des Eingangssignals in Bezug auf die zweite absolute Phase des Ausgangssignals, in Abhängigkeit von der Frequenz,
- Korrigieren des vorverzerrten ausgehenden Signals durch eine Darstellung in der Frequenzdomäne auf der Basis des Phasensteuersignals in ein phasenkorrigiertes ausgehendes Signal, und
- Ausgeben des phasenkorrigierten ausgehenden Signals, des Phasenreferenzsignals mit einem Phasenwert, identisch mit der zweiten absoluten Phase des Ausgangssignals in Bezug auf die die erste absolute Phase des Eingangssignals;
wobei die Verstärkungskorrektur und die Phasenkorrektur ein einzelnes Rückkopplungssignal in dem Rückkopplungspfad zur Ableitung des Verstärkungsreferenzsignals bzw. des Phasenreferenzsignals verwenden.

16. Computerprogrammprodukt, zu laden durch eine Anordnung nach Anspruch 6, welches Computerprogramm bei Ausführung eine frequenzabhängige Phasen- und Verstärkungsanpassung und eine amplitudenabhängige Verstärkungsanpassung in Echtzeit eines Eingangssignals in Bezug auf ein Ausgangssignal durchführt, wobei das Eingangssignal eine erste absolute Phase und eine erste Leistung in Abhängigkeit von der Frequenz hat, das Ausgangssignal eine zweite absolute Phase und eine zweite Leistung in Abhängigkeit von der Frequenz hat, das Ausgangssignal bei Verwendung in Bezug auf das Eingangssignal verstärkt wird, einschließlich einer Verstärkungskorrektur und einer Phasenkorrektur;
die Verstärkungskorrektur Folgendes umfasst:
- Empfangen des Eingangssignals, des Eingangssignals, wie dargestellt im digitalen Basisband, und eines Verstärkungsreferenzsignals von dem Rückkopplungspfad,
- Korrigieren durch eine Darstellung in der Frequenzdomäne der ersten absoluten Phase des Eingangssignals in Bezug auf die zweite absolute Phase des Ausgangssignals in Abhängigkeit von der Frequenz in ein phasenkorrigiertes ausgehendes Signal, und
- Ausgeben des phasenkorrigierten ausgehenden Signals, des Verstärkungsreferenzsignals mit einem Verstärkungswert, identisch mit der zweiten absoluten Phase des Ausgangssignals in Bezug auf die erste absolute Phase des Eingangssignals;
die Phasenkorrektur Folgendes umfasst:
- Empfangen des phasenkorrigierten ausgehenden Signals, des Eingangssignals und eines Phasenreferenzsignals von dem Rückkopplungspfad,
- Bestimmen eines Phasensteuersignals auf der Basis der ersten Leistung des Eingangssignals in Bezug auf die zweite Leistung des Ausgangssignals,
- Korrigieren des phasenkorrigierten ausgehenden Signals auf der Basis des Verstärkungssteuersignals in ein vorverzerrtes ausgehendes Signal, und
- Ausgeben des vorverzerrten ausgehenden Signals, des Verstärkungsreferenzsignals mit einem Verstärkungswert, identisch mit der zweiten Leistung des Ausgangssignals in Bezug auf die die erste Leistung des Eingangssignals,
wobei die Verstärkungskorrektur und die Phasenkorrektur ein einzelnes Rückkopplungssignal in dem Rückkopplungspfad zur Ableitung des Verstärkungsreferenzsignals bzw. des Phasenreferenzsignals verwenden.

17. Datenträger mit einem Computerprogrammprodukt nach Anspruch 15 oder 16.

## Revendications

1. Agencement pour une adaptation de phase et de gain en temps réel en fonction d'une adaptation de fréquence et de gain en fonction de l'amplitude d'un signal d'entrée par rapport à un signal de sortie, ledit signal d'entrée ayant une première phase absolue et une première puissance fonction de la fréquence, ledit signal de sortie ayant une deuxième phase absolue et une deuxième puissance fonction de la fréquence, ledit signal de sortie, en utilisation, étant amplifié par rapport audit signal d'entrée,
ledit agencement comprenant un bloc de correction de gain (2, 6), un bloc de correction de phase (9, 10), et un amplificateur de puissance (4),
ledit bloc de correction de gain (2, 6) étant connecté, au niveau d'une troisième entrée (118), de manière à recevoir ledit signal d'entrée, étant en outre connecté, sur un chemin de rétroaction, à une entrée (107) dudit amplificateur de puissance (4), via une première sortie (102) dudit bloc de correction de gain (2, 6), et via une deuxième entrée (115) dudit bloc de correction de gain (2, 6), à une sortie (108) dudit amplificateur de puissance (4) ;
ledit bloc de correction de phase (9, 10) étant connecté, au niveau d'une troisième entrée (119), de manière à recevoir ledit signal d'entrée, ledit bloc de correction de phase (9, 10) étant connecté, sur ledit chemin de rétroaction, à ladite entrée (107) dudit amplificateur de puissance (4), via une première sortie (104) dudit bloc de correction de phase (9, 10), et via une deuxième entrée (111) dudit bloc de correction de phase (9, 10), à ladite sortie (108) dudit amplificateur de puissance (4) ;
ledit bloc de correction de gain (2, 6) étant connecté, au niveau d'une première entrée (100), de manière à recevoir ledit signal d'entrée, et ledit bloc de correction de phase (9, 10) étant connecté, au niveau d'une première entrée (103), à ladite première sortie (102) dudit bloc de correction de gain,
ledit bloc de correction de gain (2, 6) étant conçu pour recevoir ledit signal d'entrée au niveau de ladite troisième entrée (118) et un signal de référence de gain au niveau de ladite deuxième entrée (115), et pour corriger ladite première puissance dudit signal d'entrée, par rapport à ladite deuxième puissance dudit signal de sortie, afin de former un signal sortant prédistordu, et pour émettre, au niveau de ladite première sortie (102), ledit signal sortant prédistordu, ledit signal de référence de gain ayant une valeur de gain identique à ladite deuxième puissance dudit signal de sortie par rapport à ladite première puissance dudit signal d'entrée,
**caractérisé en ce que**
ledit bloc de correction de phase (9, 10) est conçu pour recevoir ledit signal d'entrée tel que représenté en bande de base numérique au niveau de ladite troisième entrée (119) et un signal de référence de phase au niveau de ladite deuxième entrée (111), et pour corriger, par une représentation dans le domaine fréquentiel, la première phase absolue dudit signal d'entrée, par rapport à ladite deuxième phase absolue dudit signal de sortie, en fonction de la fréquence, afin de former un signal sortant corrigé en phase, et pour émettre, au niveau de ladite première sortie (104), ledit signal sortant corrigé en phase, ledit signal de référence de phase ayant une valeur de phase identique à ladite deuxième phase absolue dudit signal de sortie par rapport à ladite première phase absolue dudit signal d'entrée,
ledit bloc de correction de gain (2, 6) et ledit bloc de correction de phase (9, 10) utilisant un seul signal de rétroaction sur ledit chemin de rétroaction pour obtenir respectivement ledit signal de référence de gain et ledit signal de référence de phase.

2. Agencement selon la revendication 1, **caractérisé en ce que** ledit bloc de correction de phase (9, 10) comprend une deuxième sortie (114) connectée à ladite deuxième entrée (115) du bloc de correction de gain (2, 6), et le bloc de correction de phase est conçu pour émettre, au niveau de ladite deuxième sortie (114), un signal de sortie supplémentaire destiné à être transmis à ladite deuxième entrée (115) dudit bloc de correction de gain (2, 6) en tant que ledit signal de référence de gain.

3. Agencement selon l'une quelconque des revendications précédentes, **caractérisé en ce que** ledit bloc de correction de gain (2, 6) comprend un bloc de prédistorsion numérique (2) et un bloc d'estimation de transfert d'amplitude (6),
ledit bloc de prédistorsion numérique (2) comprenant une entrée de commande de gain (117), ledit bloc d'estimation de transfert d'amplitude (6) comprenant une sortie de commande de gain (116),
ladite sortie de commande de gain (116) étant connectée à ladite entrée de commande de gain (117),
ledit bloc d'estimation de transfert d'amplitude (6) étant conçu pour :
- recevoir ledit signal de référence de gain et pour recevoir, au niveau de ladite troisième entrée (118), ledit signal d'entrée, pour comparer ledit signal d'entrée audit signal de référence de gain,
- déterminer un signal de commande de gain, et
- émettre ledit signal de commande de gain au niveau de ladite sortie de commande de gain (116),
ledit bloc de prédistorsion numérique (2) étant conçu pour :
- recevoir ledit signal d'entrée au niveau de ladite première entrée (100) et ledit signal de commande de gain au niveau de ladite entrée de commande de gain (117), et
- corriger ladite première puissance dudit signal d'entrée, par rapport à ladite deuxième puissance dudit signal de sortie, en fonction de l'amplitude, au moyen dudit signal de commande de gain.

4. Agencement selon l'une quelconque des revendications précédentes, **caractérisé en ce que** ledit bloc de correction de phase (9, 10) comprend un bloc d'adaptation de phase (9) et un bloc d'estimation et de correction de phase (10),
ledit bloc d'adaptation de phase (9) comprenant une entrée de commande de phase (113),
ledit bloc d'estimation et de correction de phase (10) comprenant une sortie de commande de phase (112),
ladite sortie de commande de phase (112) étant connectée à ladite entrée de commande de phase (113),
ledit bloc d'estimation et de correction de phase (10) étant conçu pour :
- recevoir ledit signal de référence de phase et recevoir, au niveau de ladite troisième entrée (119), ledit signal d'entrée, pour comparer ledit signal d'entrée audit signal de référence de phase,
- déterminer un signal de commande de phase, et
- émettre ledit signal de commande de phase au niveau de ladite sortie de commande de phase (112),
ledit bloc d'adaptation de phase (9) étant conçu pour :
- recevoir ledit signal sortant prédistordu au niveau de ladite première entrée (103) et ledit signal de commande de phase au niveau de ladite entrée de commande de phase (113), et
- corriger ladite première phase absolue dudit signal d'entrée, par rapport à ladite deuxième phase absolue dudit signal de sortie, en fonction de la fréquence, au moyen dudit signal de commande de phase.

5. Agencement selon la revendication 4, **caractérisé en ce que** ledit bloc d'adaptation de phase (9) comprend un premier processeur de transformée de Fourier numérique (DFT), un processeur de transformée de Fourier numérique inverse (IDFT), un correcteur (CRT), et un ajusteur (ADJ),
ledit processeur de transformée de Fourier numérique (DFT) étant connecté à une première entrée dudit correcteur (CRT), ledit correcteur (CRT) étant connecté, au niveau d'une sortie, à une entrée dudit processeur de transformée de Fourier numérique inverse (IDFT), ledit ajusteur (ADJ) étant connecté, par une sortie, à une deuxième entrée dudit correcteur (CRT), ledit processeur de transformée de Fourier numérique (DFT) étant conçu pour recevoir, au niveau d'une entrée, ledit signal sortant prédistordu, et pour transformer ledit signal sortant prédistordu en un signal transformé par Fourier,
ledit ajusteur (ADJ) étant conçu pour :
- recevoir, au niveau de ladite entrée de commande de phase (113), ledit signal de commande de phase, et au niveau d'une deuxième entrée, une valeur de phase souhaitée pour ladite phase en fonction de la fréquence, et
- déterminer un signal de correction d'ajusteur,
ledit correcteur étant conçu pour :
- recevoir ledit signal transformé par Fourier et ledit signal de correction d'ajusteur, et
- déterminer et émettre un signal transformé par Fourier et corrigé,
ledit processeur de transformée de Fourier numérique inverse (IDFT) étant conçu pour recevoir ledit signal transformé par Fourier et corrigé et pour déterminer et émettre une transformée de Fourier inverse dudit signal transformé par Fourier et corrigé, en tant que ledit signal sortant corrigé en phase.

6. Agencement pour une adaptation de phase et de gain en temps réel en fonction d'une adaptation de fréquence et de gain en fonction de l'amplitude d'un signal d'entrée par rapport à un signal de sortie, ledit signal d'entrée ayant une première phase absolue et une première puissance fonction de la fréquence, ledit signal de sortie ayant une deuxième phase absolue et une deuxième puissance fonction de la fréquence, ledit signal de sortie, en utilisation, étant amplifié par rapport audit signal d'entrée,
ledit agencement comprenant un bloc de correction de gain (2, 6), un bloc de correction de phase (9, 10), et un amplificateur de puissance (4),
ledit bloc de correction de gain (2, 6) étant connecté, au niveau d'une troisième entrée (118), de manière à recevoir ledit signal d'entrée, étant en outre connecté, sur un chemin de rétroaction, à une entrée (107) dudit amplificateur de puissance (4), via une première sortie (102) dudit bloc de correction de gain (2, 6), et via une deuxième entrée (115) dudit bloc de correction de gain (2, 6), à une sortie (108) dudit amplificateur de puissance (4) ;
ledit bloc de correction de phase (9, 10) étant connecté, au niveau d'une troisième entrée (119), de manière à recevoir ledit signal d'entrée, ledit bloc de correction de phase (9, 10) étant connecté, sur ledit chemin de rétroaction, à ladite entrée (107) dudit amplificateur de puissance (4), via une première sortie (104) dudit bloc de correction de phase (9, 10), et via une deuxième entrée (111) dudit bloc de correction de phase (9, 10), à ladite sortie (108) dudit amplificateur de puissance (4) ;
ledit bloc de correction de phase (9, 10) étant connecté, au niveau d'une première entrée (103), de manière à recevoir ledit signal d'entrée, et ledit bloc de correction de gain (2, 6) étant connecté, au niveau d'une première entrée (100), à ladite première sortie (104) dudit bloc de correction de phase ;
ledit bloc de correction de gain (2, 6) étant conçu pour recevoir ledit signal d'entrée au niveau de ladite troisième entrée (118) et un signal de référence de gain au niveau de ladite deuxième entrée (115), et pour corriger ladite première puissance dudit signal d'entrée, par rapport à ladite deuxième puissance dudit signal de sortie, afin de former un signal sortant prédistordu, et pour émettre, au niveau de ladite première sortie (102), ledit signal sortant prédistordu, ledit signal de référence de gain ayant une valeur de gain identique à ladite deuxième puissance dudit signal de sortie par rapport à ladite première puissance dudit signal d'entrée,
**caractérisé en ce que**
ledit bloc de correction de phase (9, 10) est conçu pour recevoir ledit signal d'entrée tel que représenté en bande de base numérique au niveau de ladite troisième entrée (119) et un signal de référence de phase au niveau de ladite deuxième entrée (111), et pour corriger, par une représentation dans le domaine fréquentiel, la première phase absolue dudit signal d'entrée, par rapport à ladite deuxième phase absolue dudit signal de sortie, en fonction de la fréquence, afin de former un signal sortant corrigé en phase, et pour émettre, au niveau de ladite première sortie (104), ledit signal sortant corrigé en phase, ledit signal de référence de phase ayant une valeur de phase identique à ladite deuxième phase absolue dudit signal de sortie par rapport à ladite première phase absolue dudit signal d'entrée,
ledit bloc de correction de gain (2, 6) et ledit bloc de correction de phase (9, 10) utilisant un seul signal de rétroaction sur ledit chemin de rétroaction pour obtenir respectivement ledit signal de référence de gain et ledit signal de référence de phase.

7. Agencement selon la revendication 6, **caractérisé en ce que** ledit bloc de correction de gain (2, 6) comprend une deuxième sortie connectée à ladite deuxième entrée (111) du bloc de correction de phase (9, 10), et le bloc de correction de gain est conçu pour émettre, au niveau de ladite deuxième sortie, un signal de sortie supplémentaire destiné à être transmis à ladite deuxième entrée (111) dudit bloc de correction de phase (9, 10) en tant que ledit signal de référence de phase.

8. Agencement selon la revendication 6 ou la revendication 7, **caractérisé en ce que** ledit bloc de correction de gain (2, 6) comprend un bloc de prédistorsion numérique (2) et un bloc d'estimation de transfert d'amplitude (6),
ledit bloc de prédistorsion numérique (2) comprenant une entrée de commande de gain (117), ledit bloc d'estimation de transfert d'amplitude (6) comprenant une sortie de commande de gain (116),
ladite sortie de commande de gain (116) étant connectée à ladite entrée de commande de gain (117),
ledit bloc d'estimation de transfert d'amplitude (6) étant conçu pour :
- recevoir ledit signal de référence de gain et pour recevoir, au niveau de ladite troisième entrée (118), ledit signal d'entrée, pour comparer ledit signal d'entrée audit signal de référence de gain,
- déterminer un signal de commande de gain, et
- émettre ledit signal de commande de gain au niveau de ladite sortie de commande de gain (116),
ledit bloc de prédistorsion numérique (2) étant conçu pour :
- recevoir ledit signal sortant corrigé en phase au niveau de ladite première entrée (100) et ledit signal de commande de gain au niveau de ladite entrée de commande de gain (117), et
- corriger ladite première puissance dudit signal d'entrée, par rapport à ladite deuxième puissance dudit signal de sortie, en fonction de l'amplitude, au moyen dudit signal de commande de gain.

9. Agencement selon l'une quelconque des revendications précédentes 6-8, **caractérisé en ce que** ledit bloc de correction de phase (9, 10) comprend un bloc d'adaptation de phase (9) et un bloc d'estimation et de correction de phase (10),
ledit bloc d'adaptation de phase (9) comprenant une entrée de commande de phase (113),
ledit bloc d'estimation et de correction de phase (10) comprenant une sortie de commande de phase (112),
ladite sortie de commande de phase (112) étant connectée à ladite entrée de commande de phase (113),
ledit bloc d'estimation et de correction de phase (10) étant conçu pour :
- recevoir ledit signal de référence de phase et recevoir, au niveau de ladite troisième entrée (119), ledit signal d'entrée, pour comparer ledit signal d'entrée audit signal de référence de phase,
- déterminer un signal de commande de phase, et
- émettre ledit signal de commande de phase au niveau de ladite sortie de commande de phase (112),
ledit bloc d'adaptation de phase (9) étant conçu pour :
- recevoir ledit signal d'entrée au niveau de ladite première entrée (103) et ledit signal de commande de phase au niveau de ladite entrée de commande de phase (113), et
- corriger ladite première phase absolue dudit signal d'entrée, par rapport à ladite deuxième phase absolue dudit signal de sortie, en fonction de la fréquence, au moyen dudit signal de commande de phase.

10. Agencement selon la revendication 9, **caractérisé en ce que** ledit bloc d'adaptation de phase (9) comprend un premier processeur de transformée de Fourier numérique (DFT), un processeur de transformée de Fourier numérique inverse (IDFT), un correcteur (CRT), et un ajusteur (ADJ),
ledit processeur de transformée de Fourier numérique (DFT) étant connecté à une première entrée dudit correcteur (CRT), ledit correcteur (CRT) étant connecté, au niveau d'une sortie, à une entrée dudit processeur de transformée de Fourier numérique inverse (IDFT), ledit ajusteur (ADJ) étant connecté, par une sortie, à une deuxième entrée dudit correcteur (CRT), ledit processeur de transformée de Fourier numérique (DFT) étant conçu pour recevoir, au niveau d'une entrée, ledit signal d'entrée, et pour transformer ledit signal d'entrée en un signal transformé par Fourier,
ledit ajusteur (ADJ) étant conçu pour :
- recevoir, au niveau de ladite entrée de commande de phase (113), ledit signal de commande de phase, et au niveau d'une deuxième entrée, une valeur de phase souhaitée pour ladite phase en fonction de la fréquence, et
- déterminer un signal de correction d'ajusteur,
ledit correcteur étant conçu pour :
- recevoir ledit signal transformé par Fourier et ledit signal de correction d'ajusteur, et
- déterminer et émettre un signal transformé par Fourier et corrigé,
ledit processeur de transformée de Fourier numérique inverse (IDFT) étant conçu pour recevoir ledit signal transformé par Fourier et corrigé et pour déterminer et émettre une transformée de Fourier inverse dudit signal transformé par Fourier et corrigé, en tant que ledit signal sortant corrigé en phase.

11. Agencement selon l'une quelconque des revendications précédentes, **caractérisé en ce que** ladite entrée dudit amplificateur de puissance (4) comprend un convertisseur numérique-analogique et élévateur de fréquence (3), et la sortie dudit amplificateur de puissance (4) comprend un convertisseur analogique-numérique et abaisseur de fréquence (5),
dans lequel ledit convertisseur numérique-analogique et élévateur de fréquence (3) est disposé sur ledit chemin de rétroaction, entre, d'une part, les premières entrées (102, 104) dudit bloc de correction de gain (2, 6) et dudit bloc de correction de phase (9, 10), et d'autre part, ladite entrée (107) dudit amplificateur de puissance (4), et ledit convertisseur analogique-numérique et abaisseur de fréquence (5) est disposé sur ledit chemin de rétroaction, entre, d'une part, ladite sortie (108) dudit amplificateur de puissance (4), et d'autre part, lesdites deuxièmes entrées (111, 115) dudit bloc de correction de phase (9, 10) et dudit bloc de correction de gain (2, 6).

12. Agencement selon la revendication 4 ou la revendication 7, **caractérisé en ce que** ledit bloc d'estimation et de correction de phase (10) comprend un corrélateur croisé (XC), un processeur temporel (TP), un deuxième processeur de transformée de Fourier numérique (DFT2), et un processeur spectral (SP),
ledit corrélateur croisé XC étant connecté, au niveau d'une sortie, à une entrée dudit processeur temporel (TP), ledit processeur temporel (TP) étant connecté, au niveau d'une sortie, à une entrée dudit deuxième processeur de transformée de Fourier numérique (DFT2), ledit deuxième processeur de transformée de Fourier numérique (DFT2) étant connecté, au niveau d'une sortie, à une entrée dudit processeur spectral (SP), ledit processeur spectral SP ayant ladite sortie de commande de phase (112),
ledit corrélateur croisé (XC) étant conçu pour :
- recevoir, sur ladite troisième entrée (119), ledit signal d'entrée, et sur ladite deuxième entrée (111), ledit signal de référence de phase,
- déterminer, synchroniser et soumettre à une corrélation croisée ledit signal d'entrée et ledit signal de référence de phase en un signal soumis à une corrélation croisée, et
- envoyer ledit signal soumis à une corrélation croisée audit processeur temporel (TP),
ledit processeur temporel (TP) étant conçu pour :
- recevoir ledit signal soumis à une corrélation croisée en provenance dudit corrélateur croisé (XC),
- adapter ledit signal soumis à une corrélation croisée en un signal soumis à une corrélation croisée et modifié, adapté pour une transformée de Fourier, et
- envoyer ledit signal soumis à une corrélation croisée et modifié audit deuxième processeur de transformée de Fourier numérique (DFT2), ledit processeur de transformée de Fourier numérique (DFT2) étant conçu pour :
- recevoir ledit signal soumis à une corrélation croisée et modifié,
- calculer un signal de spectre de puissance à partir dudit signal soumis à une corrélation croisée et modifié, et
- envoyer ledit signal de spectre de puissance audit processeur spectral (SP),
ledit processeur spectral (SP) étant conçu pour :
- recevoir ledit signal de spectre de puissance,
- déterminer au moins une estimation d'une phase en fonction de la fréquence, à partir dudit signal de spectre de puissance, en tant que signal phase-fréquence, et
- envoyer ledit signal phase-fréquence en tant que ledit signal de commande de phase audit bloc d'adaptation de phase (9).

13. Procédé à exécuter par un agencement tel que défini dans la revendication 1, pour une adaptation de phase et de gain en temps réel en fonction d'une adaptation de fréquence et de gain en fonction de l'amplitude d'un signal d'entrée par rapport à un signal de sortie, ledit signal d'entrée ayant une première phase absolue et une première puissance fonction de la fréquence, ledit signal de sortie ayant une deuxième phase absolue et une deuxième puissance fonction de la fréquence, ledit signal de sortie, en utilisation, étant amplifié par rapport audit signal d'entrée,
ledit procédé comprenant une correction de gain et une correction de phase ;
ladite correction de gain comprenant les étapes consistant à :
- recevoir ledit signal d'entrée tel que représenté en bande de base numérique et un signal de référence de gain en provenance d'un chemin de rétroaction,
- corriger ladite première puissance dudit signal d'entrée, par rapport à ladite deuxième puissance dudit signal de sortie, en un signal sortant prédistordu, et
- émettre ledit signal sortant prédistordu, ledit signal de référence de gain ayant une valeur de gain identique à ladite deuxième puissance dudit signal de sortie par rapport à ladite première puissance dudit signal d'entrée,
ledit procédé comprenant une correction de phase ;
ladite correction de phase comprenant les étapes consistant à :
- recevoir ledit signal sortant prédistordu, ledit signal d'entrée et un signal de référence de phase en provenance dudit chemin de rétroaction,
- déterminer un signal de commande de phase sur la base de ladite première phase absolue dudit signal d'entrée, par rapport à ladite deuxième phase absolue dudit signal de sortie, en fonction de la fréquence,
- corriger ledit signal sortant prédistordu par une représentation dans le domaine fréquentiel sur la base du signal de commande de phase, en un signal sortant corrigé en phase,
et
- émettre ledit signal sortant corrigé en phase, ledit signal de référence de phase ayant une valeur de phase identique à ladite deuxième phase absolue dudit signal de sortie par rapport à ladite première phase absolue dudit signal d'entrée,
ladite correction de gain et ladite correction de phase utilisant un seul signal de rétroaction sur ledit chemin de rétroaction pour obtenir respectivement ledit signal de référence de gain et ledit signal de référence de phase.

14. Procédé à exécuter par un agencement tel que défini dans la revendication 6, pour une adaptation de phase et de gain en temps réel en fonction d'une adaptation de fréquence et de gain en fonction de l'amplitude d'un signal d'entrée par rapport à un signal de sortie, ledit signal d'entrée ayant une première phase absolue et une première puissance fonction de la fréquence, ledit signal de sortie ayant une deuxième phase absolue et une deuxième puissance fonction de la fréquence, ledit signal de sortie, en utilisation, étant amplifié par rapport audit signal d'entrée,
ledit procédé comprenant une correction de gain et une correction de phase ;
ladite correction de phase comprenant les étapes consistant à :
- recevoir ledit signal d'entrée tel que représenté en bande de base numérique et un signal de référence de phase en provenance dudit chemin de rétroaction,
- corriger, par une représentation dans le domaine fréquentiel, ladite première phase absolue dudit signal d'entrée, par rapport à ladite deuxième phase absolue dudit signal de sortie, en fonction de la fréquence, en un signal sortant corrigé en phase, et
- émettre ledit signal sortant corrigé en phase, ledit signal de référence de phase ayant une valeur de phase identique à ladite deuxième phase absolue dudit signal de sortie par rapport à ladite première phase absolue dudit signal d'entrée,
ladite correction de gain comprenant les étapes consistant à :
- recevoir ledit signal sortant corrigé en phase, ledit signal d'entrée et un signal de référence de gain en provenance dudit chemin de rétroaction,
- déterminer un signal de commande de gain sur la base de ladite première puissance dudit signal d'entrée, par rapport à ladite deuxième puissance dudit signal de sortie,
- corriger ledit signal sortant corrigé en phase sur la base dudit signal de commande de gain, en un signal sortant prédistordu, et
- émettre ledit signal sortant prédistordu, ledit signal de référence de gain ayant une valeur de gain identique à ladite deuxième puissance dudit signal de sortie par rapport à ladite première puissance dudit signal d'entrée,
ladite correction de gain et ladite correction de phase utilisant un seul signal de rétroaction sur ledit chemin de rétroaction pour obtenir respectivement ledit signal de référence de gain et ledit signal de référence de phase.

15. Produit de programme informatique destiné à être chargé par un agencement tel que défini dans la revendication 1, ledit produit de programme informatique accomplissant, lorsqu'il est exécuté, une adaptation de phase et de gain en temps réel en fonction d'une adaptation de fréquence et de gain en fonction de l'amplitude d'un signal d'entrée par rapport à un signal de sortie, ledit signal d'entrée ayant une première phase absolue et une première puissance fonction de la fréquence, ledit signal de sortie ayant une deuxième phase absolue et une deuxième puissance fonction de la fréquence, ledit signal de sortie, en utilisation, étant amplifié par rapport audit signal d'entrée, incluant une correction de gain et une correction de phase ;
ladite correction de gain comprenant les étapes consistant à :
- recevoir ledit signal d'entrée tel que représenté en bande de base numérique et un signal de référence de gain en provenance d'un chemin de rétroaction,
- corriger ladite première puissance dudit signal d'entrée, par rapport à ladite deuxième puissance dudit signal de sortie, en un signal sortant prédistordu, et
- émettre ledit signal sortant prédistordu, ledit signal de référence de gain ayant une valeur de gain identique à ladite deuxième puissance dudit signal de sortie par rapport à ladite première puissance dudit signal d'entrée,
ladite correction de phase comprenant les étapes consistant à :
- recevoir ledit signal sortant prédistordu, ledit signal d'entrée et un signal de référence de phase en provenance dudit chemin de rétroaction,
- déterminer un signal de commande de phase sur la base de ladite première phase absolue dudit signal d'entrée, par rapport à ladite deuxième phase absolue dudit signal de sortie, en fonction de la fréquence,
- corriger ledit signal sortant prédistordu par une représentation dans le domaine fréquentiel sur la base du signal de commande de phase, en un signal sortant corrigé en phase, et
- émettre ledit signal sortant corrigé en phase, ledit signal de référence de phase ayant une valeur de phase identique à ladite deuxième phase absolue dudit signal de sortie par rapport à ladite première phase absolue dudit signal d'entrée,
ladite correction de gain et ladite correction de phase utilisant un seul signal de rétroaction sur ledit chemin de rétroaction pour obtenir respectivement ledit signal de référence de gain et ledit signal de référence de phase.

16. Produit de programme informatique destiné à être chargé par un agencement tel que défini dans la revendication 6, ledit produit de programme informatique accomplissant, lorsqu'il est exécuté, une adaptation de phase et de gain en temps réel en fonction d'une adaptation de fréquence et de gain en fonction de l'amplitude d'un signal d'entrée par rapport à un signal de sortie, ledit signal d'entrée ayant une première phase absolue et une première puissance fonction de la fréquence, ledit signal de sortie ayant une deuxième phase absolue et une deuxième puissance fonction de la fréquence, ledit signal de sortie, en utilisation, étant amplifié par rapport audit signal d'entrée, incluant une correction de gain et une correction de phase,
ladite correction de phase comprenant les étapes consistant à :
- recevoir ledit signal d'entrée, ledit signal d'entrée tel que représenté en bande de base numérique et un signal de référence de phase en provenance dudit chemin de rétroaction,
- corriger, par une représentation dans le domaine fréquentiel, ladite première phase absolue dudit signal d'entrée, par rapport à ladite deuxième phase absolue dudit signal de sortie, en fonction de la fréquence, en un signal sortant corrigé en phase, et
- émettre ledit signal sortant corrigé en phase, ledit signal de référence de phase ayant une valeur de phase identique à ladite deuxième phase absolue dudit signal de sortie par rapport à ladite première phase absolue dudit signal d'entrée,
ladite correction de gain comprenant les étapes consistant à :
- recevoir ledit signal sortant corrigé en phase, ledit signal d'entrée et un signal de référence de gain en provenance dudit chemin de rétroaction,
- déterminer un signal de commande de gain sur la base de ladite première puissance dudit signal d'entrée, par rapport à ladite deuxième puissance dudit signal de sortie,
- corriger ledit signal sortant corrigé en phase sur la base dudit signal de commande de gain, en un signal sortant prédistordu, et
- émettre ledit signal sortant prédistordu, ledit signal de référence de gain ayant une valeur de gain identique à ladite deuxième puissance dudit signal de sortie par rapport à ladite première puissance dudit signal d'entrée,
ladite correction de gain et ladite correction de phase utilisant un seul signal de rétroaction sur ledit chemin de rétroaction pour obtenir respectivement ledit signal de référence de gain et ledit signal de référence de phase.

17. Support de données contenant un produit de programme informatique selon la revendication 15 ou la revendication 16.
